# EUROPÄISCHE PATENTSCHRIFT

(11) **EP 1 768 200 B1**
(45) Veröffentlichungstag und Bekanntmachung des Hinweises auf die Patenterteilung: **07.05.2008**
(21) Anmeldenummer: 06025887.8
(22) Anmeldetag: 03.03.2005
(51) Int. Cl.: H01L 51/00

(54) **Metallkomplex und Verfahren zu seiner Herstellung**
Dopant and its production method
Dopant et sa méthode de fabrication

(30) Priorität: 03.03.2004 DE 102004010954
(43) Veröffentlichungstag der Anmeldung: 28.03.2007
(62) Teilanmeldung aus: 05729708.7
(73) Patentinhaber: Novaled AG, 01307 Dresden (DE)
(72) Erfinder: Werner, Ansgar, 01277 Dresden (DE); Kühl, Olaf, 04416 Markkleeberg (DE); Gessler, Simon, 60594 Franfurt am Main (DE); Harada, Kentaro, 01307 Dresden (DE); Hartmann, Horst, 01326 Dresden (DE); Grüßing, André, 01307 Dresden (DE); Limmert, Michael, 01277 Dresden (DE); Lux, Andrea, 01309 Dresden (DE)
(74) Vertreter: Bittner, Thomas L.

(56) Entgegenhaltungen:
- WO-A-03/088271
- US-A1- 2002 142 189
- US-A1- 2003 203 168
- U. RADIUS AND J. ATTNER: "Dinuclear Molybdenum(III) and Tungsten(III) Calix[4]arene Complexes - Metal-Metal Triple Bonds Supported by Bridging Calix[4]arene Ligands" EUROPEAN JOURNAL OF INORGANIC CHEMISTRY, Nr. 3, 7. Dezember 1998 (1998-12-07), Seiten 299-303, XP002347767
- M. H. CHISHOLM ET AL: "Preparation and characterization of the kinetic and thermodynamic isomers of dinuclear molybdenum and tungsten complexes with metal?metal triple bonds supported by p-tert-butylcalix[4]arene anions" CHEMICAL COMMUNICATIONS, Nr. 3, 1998, Seiten 379-380, XP002347768

## Beschreibung

Die Erfindung betrifft Metallkomplexe und Verfahren zu ihrer Herstellung.

Es ist bekannt, organische Halbleiter durch Dotierung hinsichtlich ihrer elektrischen Eigenschaften, insbesondere ihrer elektrischen Leitfähigkeit, zu verändern, wie dies auch bei anorganischen Halbleitern wie Siliciumhalbleitern der Fall ist. Hierbei wird durch Erzeugung von Ladungsträgern im Matrixmaterial eine Erhöhung der zunächst recht niedrigen Leitfähigkeit sowie je nach Art des verwendeten Dotanden eine Veränderung im Fermi-Niveau des Halbleiters erreicht. Eine Dotierung führt hierbei zu einer Erhöhung der Leitfähigkeit von Ladungstransportschichten, wodurch ohmsche Verluste verringert werden, und zu einem verbesserten Übergang der Ladungsträger zwischen Kontakten und organischer Schicht. Anorganische Dotanden sind bei organischen Matrixmaterialien aufgrund ihrer hohen Diffusionskoeffizienten meist nachteilig, da sie die Funktion und Stabilität der elektronischen Bauelemente beeinträchtigen. Ferner ist es bekannt, Dotanden über chemische Reaktionen in dem halbleitenden Matrixmaterial freizusetzen, um Dotanden bereitzustellen. Das Oxidationspotential der derart freigesetzten Dotanden ist jedoch für verschiedene Anwendungsfälle wie insbesondere für organische Leuchtdioden (OLED) oftmals nicht ausreichend. Ferner werden bei Freisetzung der Dotanden auch weitere Verbindungen und/oder Atome, beispielsweise atomarer Wasserstoff, erzeugt, wodurch die Eigenschaften der dotierten Schicht bzw. des korrespondierenden elektronischen Bauelementes beeinträchtigt werden.

Ferner haben als Dotanden verwendete organische Verbindungen oftmals ein nicht ausreichend niedriges Oxidationspotential für den jeweiligen Anwendungsfall.

U. Radius und J. Attner, Eur. J. Inorg. Chem. 1998, 299-303 beschreiben zweikernige Molybdänen(III)- und Wolfram(III)-Calix[4]arenkomplexe, das heißt Metall-Metall-Dreifachbindungen, die durch verbrückende Calix[4]arenliganden gestützt werden.

M. H. Chisholm, K. Folting, W. E. Streib und D.-D. Wu, Chem. Commun., 1998, 379-380 beschreiben die Herstellung und Charakterisierung der kinetischen und thermodynamischen Isomere von zweikernigen Molybdän- und Wolframkomplexen mit Metall-Metall-Dreifachbindungen, die durch p-tert-Butylcalix[4]arenanionen gestützt werden.

WO 03/088271 offenbart die Verwendung eines neutralen Metallkomplexes wie z.B. Ferrocen als n-Dotanden.

US 2003/203168 offenbart dinucleare Wolframverbindungen welche in einem molekularen Schalter verwendet werden.

Der Erfindung liegt die Aufgabe zugrunde, Metallkomplexe als n-Dotanden zur Dotierung eines organischen halbleitenden Matrixmaterials, insbesondere zur Herstellung elektronischer Bauelemente anzugeben, die insbesondere auch zur Herstellung von E-lektronentransportmaterialien für organische Leuchtdioden (OLED) ausreichend niedrige Oxidationspotentiale aufweisen, ohne störende Einflüsse auf das Matrixmaterial zu haben, und eine wirksame Erhöhung der Ladungsträgeranzahl in dem Matrixmaterial bewirken und vorzugsweise vergleichsweise einfach handhabbar sind. Ferner ist es eine Aufgabe der Erfindung, Verfahren zur Herstellung der Metallkomplexe bereitzustellen.

Diese Aufgaben werden durch die Merkmale der unabhängigen Ansprüche gelöst. Ferner wird ein organisches halbleitendes Material mit einer Verbindung eines solchen neutralen elektronenreichen Metallkomplexes als n-Dotand bereitgestellt. Bevorzugte Ausführungsformen ergeben sich aus den Unteransprüchen.

Dadurch, dass ein elektronenreicher Metallkomplex in neutraler Form als n-Dotand gegenüber dem organischen halbleitenden Matrixmaterial eingesetzt wird, liegt ein wesentlich stärkerer Donor vor, als bei bisher bekannten organischen Donorverbindungen. Ferner können durch die Bereitstellung eines neutralen elektronenreichen Metallkomplexes gegenüber anderen n-Dotanden in Form organischer Verbindung die Donor-Eigenschaften der Verbindung durch Auswahl eines geeigneten Zentralatoms und damit deren Oxidationspotential variiert werden. Die erfindungsgemäßen n-Dotanden weisen somit vorzugsweise ein sehr niedriges Oxidationspotential auf. Insbesondere kann durch die erfindungsgemäßen Metallkomplexe die Leitfähigkeit von Ladungstransportschichten wesentlich erhöht und/oder der Übergang der Ladungsträger zwischen Kontakten und organischer Schicht bei Anwendungen als elektronisches Bauelement wesentlich verbessert werden.

Die erfindungsgemäßen Metallkomplexe stellen vorzugsweise isolierte Moleküle dar, die somit vorzugsweise in der jeweiligen halbleitenden Schicht als isolierte Moleküle vorliegen, die nicht durch chemische Bindungen untereinander und/oder an eine Matrix und/oder an eine andere Komponente fixiert sind. Vorzugsweise werden die Valenzelektronen der Metallzentralatome, abgesehen von den dem Metallatom unmittelbar zuzuordnenden Valenzelektronen des Komplexes, somit im wesentlichen oder vollständig von den Liganden des Komplexes und den Metallatomen des Komplexes, die innerhalb der durch die Liganden gebildeten vorzugsweise zumindest im wesentlichen geschlossenen Koordinationssphäre angeordnet sind, bereitgestellt. Es versteht sich, dass einzelne Metallkomplexe jeweils untereinander oder mit anderen Komponenten wie dem Matrixmaterial gebunden sein können, um gegebenenfalls die Metallkomplexe zu immobilisieren. Hierzu können beispielsweise die Liganden geeignete funktionelle Gruppen aufweisen, die miteinander verbindbar sind, beispielsweise ungesättigte Gruppen, die miteinander unter Bildung eines Oligomeren oder Polymeren linear oder verzweigt reagieren können.

Das komplexierte Zentralatom kann eine formale Valenzelektronenzahl VE von 16 oder mehr aufweisen, beispielsweise 18 oder 19 oder 20 oder 21 oder mehr Valenzelektronen. Das Zentralatom kann hierbei insbesondere ein Metallatom der ersten Übergangsmetallperiode, ein Metallatom der zweiten Übergangsmetallperiode oder ein Metallatom der dritten Übergangsmetallperiode darstellen. Unabhängig hiervon oder in Kombination hiermit sind die erfindungsgemäßen Komplexe zumindest zweikernige Komplexe mit einer Metall-Metall-Bindung zwischen den Zentralatomen, wodurch jeweils besonders elektronenreiche Metallkomplexe mit einer hohen Elektronendichte am Zentralatom des Metallkomplexes bereitgestellt werden können.

Besonders bevorzugt ist als Zentralatom des elektronenreichen Metallkomplexes ein neutrales oder geladenes Übergangsmetallatom. Das Zentralatom kann beispielsweise ein Metallatom aus der Gruppe der ersten Übergangsmetallperiode (Scandium bis Zink) sein, oder ein Metall der zweiten Übergangsmetallperiode (Yttrium bis Cadmium), z.B. Rhodium, Palladium, Silber und Cadmium sein, oder ein Metall der dritten Übergangsmetallperiode, einschließlich jeweils Lanthaniden und Actiniden. Das Zentralatom kann insbesondere ein Metall der 7. bis 10. Gruppe sein. Das Übergangsmetall des mindestens einen Zentralatoms kann auch jeweils eines der folgenden Elemente sein: V, Cr, Mn, Fe, Co, Ni, Cu, Zn, Nd, Ta, Mo, W, Rh, Ir, Pd, Pt. Besonders bevorzugt ist das Übergangsmetallatom ausgewählt aus der Gruppe Mn, Fe, Co, Ni, Cu, Zn, beispielsweise ausgewählt aus der Gruppe Fe, Co, Ni. Ferner kann das Übergangsmetallatom ausgewählt sein aus der Gruppe Cr, Mo, W. Das Übergangsmetallatom kann auch ausgewählt sein aus der Gruppe V, Nb, Ta oder aus der Gruppe Ir, Pt, Au, Hg. Für verschiedene Anwendungszwecke sind jedoch auch Metallkomplexe mit einer geringeren formalen Valenzelektronenzahl am Metallzentralatom des Komplexes bzw. mit einer niedrigeren Elektronendichte am Metallzentralatom einsetzbar.

Das Übergangsmetallatom kann in dem erfindungsgemäß verwendeten neutralen Metallkomplex als Neutralatom vorliegen oder als geladenes Übergangsmetallatom, vorzugsweise mit einer Formalladung von 0 bis 3, beispielsweise einer Formalladung von 0, 1 oder 2, wobei das Zentralatom insbesondere ein Atom der ersten Übergangsmetallperiode darstellen kann. Die Ladung des Zentralatoms, welches ein Atom der ersten, zweiten oder dritten Übergangsmetallperiode darstellen kann, kann auch von 0 verschieden sein.

Der erfindungsgemäße Metallkomplex ist ein mehrkerniger Metallkomplex. Der Metallkomplex ist ein mehrkerniger Metallkomplex mit vier Liganden, die an zwei Metallzentralatome binden. Der Metallkomplex weist hierbei eine Metall-Metall-Bindungen auf, die jeweils Metall-Metall-Einfachbindung oder Metall-Metall-Mehrfachbindung darstellen kann. Die Metallkomplexe stellen jeweils vorzugsweise isolierte Moleküle dar.

Die Metallatome mehrkerniger Metallkomplexe sind sämtlich Übergangsmetallatome, insbesondere der 6ten oder 7ten bis 10ten Gruppe, beispielsweise ausgewählt aus der Gruppe Cr, Mn, Fe, Co, Ni, Cu, Zn, Mo, W.

Ein derartiger Metallkomplex kann beispielsweise ein sogenannter Paddlewheel-Komplex 65 sein, wobei zwei Metallzentralatome, insbesondere Übergangsmetallzentralatome durch 4 zweizähnige Liganden, die an beide Metallzentralatome jeweils ein Ligandenatom binden, überbrückt werden. Die Metallatome sind hierbei 4-fach koordiniert:

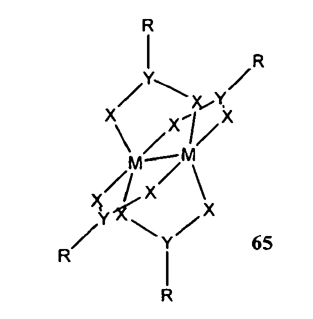

Eines oder beide Metallzentralatome M können wahlweise auch jeweils unabhängig voneinander mit zumindest einem weiteren Liganden komplexiert sein, wie beispielsweise Phosphin oder andere, die insbesondere axial (terminal) zu der M-M-Bindung angeordnet sein können.

Insbesondere können die mehrkernigen Metallkomplexe mindestens ein Atom aus der Gruppe Mn, Fe, Co, Ni, Cu, Zn, insbesondere ein Atom aus der Gruppe Fe, Co, Ni oder mindestens ein Atom ausgewählt aus der Gruppe Cr, Mo, W, insbesondere auch Mo, W aufweisen, wobei vorzugsweise sämtliche Zentralatome des neutralen Metallkomplexes identisch sind. Generell kann M ein Übergangsmetallatom sein, beispielsweise ein Übergangsmetallatom der ersten, der zweiten oder der dritten Übergangsmetallperiode oder ein Atom der 6ten oder 7ten bis 10ten Übergangsmetallgruppe. Beide Metallatome M können hierbei jeweils gleich oder verschieden voneinander sein.

Aus der oben genannten Aufzählung werden die Strukturtypen 65a, 65b, 65c und 65d beansprucht, die im Folgenden näher beschrieben werden: 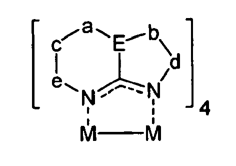 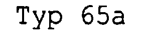 wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀,Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; 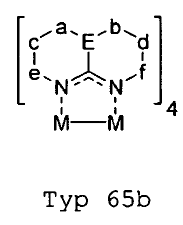 wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, wobei hiervon die Struktur 65b mit R₁, R₂, R₃, R₄, R₅, R₆, R₇, R₈, R₉, R₁₀, R₁₁ und R₁₂ = H ausgenommen ist, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 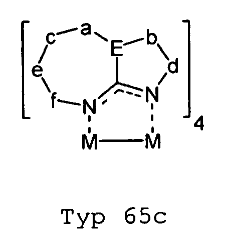 wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 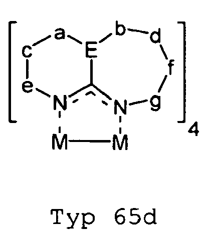
- wobei die Strukturelemente a-g die Bedeutung: a = - CR₁R₂-, b = -CR₃R₄-, c = -CR₅R₆-, d = -CR₇R₈-, e = - CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann
- wobei das Metall M ein Übergangsmetall ist, vorzugsweise W oder Mo.
Für die Reste R in den Strukturen 65a-65d sind die Definitionen für die Struktur 65, wie oben beschrieben, einsetzbar.

### Ionisationspotential/Oxidationspotential

Vorzugsweise weist der erfindungsgemäße Metallkomplex ein Ionisationspotential in der Gasphase von ≤ 6,4 eV, vorzugsweise von ≤ 6 eV, insbesondere ≤ 5,5 eV auf. Insbesondere kann das Ionisationspotential des Komplexes in der Gasphase ≤ 5,0 eV oder ≤ 4,5 eV sein.

Das Gasphasenionisationspotential Ipg der erfindungsgemäß einsetzbaren Verbindungen kann beispielsweise gegenüber Tetrathiafulvalen (TTF) bestimmt werden, welches beträgt: Ipg = 6,4 eV (siehe R. Gleiter, E. Schmidt, D. O. Cowan, J P. Ferraris, J. Electr. Spec. Rel. Phenom. 2, 207 (1973)).

Das Oxidationspotential von TTF ist E1/2(ox) = -0,09 V gegenüber Fe/Fe+ (Ferrocen/Ferrocenium) (M. Iyoda, T. Takano, N. O-tani, K. Ugawa, M. Yoshida, H. Matsuyama, Y. Kuwatani, Chem. Lett., 1310 (2001)). Ausgehend von diesem Referenzpunkt kann somit das Redoxpotential der erfindungsgemäßen n-Dotanden gegenüber Ferrocen/Ferrocenium ≤ -0,09 V, vorzugsweise ≤ -0,6 V, besonders bevorzugt ≤ -1,1 V betragen, beispielsweise ≤ -1,6 V oder ≤ -2,1 V betragen, ohne hierauf beschränkt zu sein.

Das Oxidationspotential gegenüber Ferrocen/Ferrocenium kann beispielsweise cyclovoltammetrisch bestimmt werden. Das Potential ist hierbei weitgehend unabhängig von dem gewählten Elektrolytsystem und kann gemäß IUPAC Empfehlung (Gritzner, G.; Kuta, J. Pure Appl. Chem. 1984, 56, 461-466) bestimmt werden. Das Elektrolytsystem muss ein ausreichend großes elektrochemisches Fenster und eine ausreichende Löslichkeit der Donorverbindung aufweisen. Als Elektrolytsystem ist beispielsweise geeignet A-cetronitril / 1M LiClO₄/Pt Elektroden, wobei auch andere geeignete Elektrolytsysteme einsetzbar sind.

### Dampdfruck

Der Dampfdruck des erfindungsgemäß eingesetzten Komplexes kann insbesondere bei 30°C < 10⁻³ Pa sein, beispielsweise ≤ 5 x 10⁻⁴ Pa oder ≤ 1 x 10⁻⁴ Pa.

Die jeweils verwendeten erfindungsgemäßen n-Dotanden und/oder die jeweils verwendeten Komplexe können luftstabil sein, gegebenenfalls können die jeweils verwendeten erfindungsgemäßen n-Dotanden und/oder Komplexe jeweils auch luftinstabil sein.

### Synthese der erfindungsgemäßen Metallkomplexe und deren Liganden

Es wurde ein neues Verfahren entwickelt, nach dem sich die Paddlewheel Komplexe vom Typ 65a-d effizient in einer Einstufensynthese darstellen lassen. Dazu wird ein entsprechendes anorganisches Metallsalz mit freien Basen der in 65 a-d angegebenen Liganden und einem geeigneten starken Reduktionsmittel in einem geeigneten organischen Lösungsmittel zum Rückfluß erhitzt, bis die Umsetzung vollständig abgelaufen ist. Als geeignete Lösungsmittel werden vorzugsweise solche eingesetzt, in denen die gebildeten Komplexe eine hinreichende Stabilität aufweisen, vorzugsweise jedoch Dialkylether, cyclische Ether, cyclische und offenkettige Polyether wie 1,4-Dioxan, Dimethoxyethan, etc., Aromaten und Mischungen derselben.
Geeignete Reduktionsmittel sind beispielsweise unedle Metalle, bevorzugt Alkalimetalle wie Natrium, Kalium und Cäsium.
Die Komplexe werden nach Abtrennen der anorganischen Nebenprodukte durch Kristallisation, Fällen oder Sublimation isoliert.

Durch die neuartige Einstufensynthese wird ein zeit und resourcensparender Zugang zu Komplexen des Typs W₂L₄ eröffnet.

### Im Weiteren folgen Ausführungsbeispiele:

### Synthese der Liganden und ihrer Vorstufen

### Beispiel 1:

### 1. Imidazo[1,2-a]pyrimidin Hydroperchlorat

Die Herstellung erfolgte nach einer in der Literatur beschriebenen Methode (M. Künstlinger, E. Breitmaier, Synthesis 1983 (2), 161-162). Davon abweichend wurde das Produkt durch Zugabe von Perchlorsäure als Imidazo[1,2-a]pyrimidin Hydroperchlorat isoliert.
Fp. 195 °C
¹H-NMR (500 MHz, CD₃CN) [ppm]:
8,99-8,96 (m, 2H); 7,98 (d, 1H); 7,93 (d, 1H); 7,58 (dd, 1H)
MS: m/z = 119 [M]⁺

### 2. 5,6,7,8-Tetrahydro-imidazo[1,2-a]pyrimidin

4,2 g Imidazo[1,2-a]pyrimidin Hydroperchlorat wurden in essigsaurer Lösung mit Palladium auf Aktivkohle 8 h unter H₂-Zufuhr erwärmt. Anschließende Filtration, Entfernen des Lösungsmittels und Zugabe von Diethylether lieferte das 5,6,7,8-Tetrahydroimidazo[1,2-a]pyrimidin Hydroacetat als farblose Kristalle, die aus Ethanol umkristallisiert wurden.
Ausbeute: 3,21 g
Fp. 65°C
¹H-NMR (500 MHz, DMSO-d₆) [ppm] :
6,97 (d, 1H); 6,91 (d, 1H); 3,90 (t, 2H); 3,25 (t, 2H); 1,98 (quint., 2H)

Die Freisetzung des 5,6,7,8-Tetrahydro-imidazo[1,2-a]pyrimidins erfolgte in alkalischer Ethanollösung.
Ausbeute: 3,08 g
Fp. 110°C
¹H-NMR (500 MHz, DMSO-d₆) [ppm]:
6,51 (d, 1H); 6,36 (d, 1H); 6,09 (s, 1H); 3,80 (t, 2H); 3,16 (t, 2H); 1,90 (quint., 2H)
MS: m/z = 123 [M]⁺

### Beispiel 2:

### 1. 2-Amino-4,6-dimethyl-1,4,5,6-tetrahydropyrimidin

1 g 2-Amino-4,6-dimethylpyrimidin wurden im salzsauren Milieu (2 M HCl) mit Palladium auf Aktivkohle als Katalysator für 14 h unter H₂-Zufuhr erwärmt. Anschließende Filtration, Entfernung des Lösungsmittels und Zugabe von Diethylether lieferte das 2-Amino-4,6-dimethyl-1,4,5,6-tetrahydropyrimidin Hydrochlorid, das aus i-Propanol/Diethylether umkristallisiert und im Vakuum getrocknet wurde.
Ausbeute: 1,03 g
Fp. 129°C
¹H-NMR (500 MHz, DMSO-d₆) [ppm] :
8,14 (s, 2H); 6,81 (s, 2H); 3,48 (m, 2H); 1,98 (d, 1H); 1,14 (d, 6H); 1,10 (d, 1H)

Die Freisetzung des 2-Amino-4,6-dimethyl-1,4,5,6-tetrahydropyrimidins erfolgte in alkalischer Ethanollösung.
¹H-NMR (500 MHz, DMSO-d₆) [ppm]:
3,46 (m, 2H); 1,98 (m, 1H); 1,13 (d, 6H); 1,10 (d, 1H)

### 2. 2,4-Dimethyl-3,4-dihydro-2H-pyrimido[1,2-a]pyrimidin Hydroperchlorat

0,66 g 2-Amino-4,6-dimethyl-1,4,5,6-tetrahydropyrimidin wurden in methanolischer Lösung unter Zugabe von Perchlorsäure mit einer äquimolaren Menge von 1,1,3,3-Tetramethoxypropan unter Rückfluss zum Sieden erhitzt. Entfernung des Lösungsmittel und Überschichten des Rückstandes mit Diethylether lieferte das 2,4-Dimethyl-3,4-dihydro-2H-pyrimido[1,2-a]pyrimidin Hydroperchlorat, das abfiltriert und im Vakuum getrocknet wurde.
Ausbeute: 0,46 g
¹H-NMR (500 MHz, DMSO-d₆) [ppm] :
9,86 (s, 1H); 8,75 (dd, 1H); 8,55 (dd, 1H); 6,99 (dd, 1H); 4,43 (m, 1H); 3,76 (m, 1H); 2,29 (m, 1H); 1,69 (quar, 1H); 1,57 (d, 3H); 1,27 (d, 3H)

### 3. 2,4-Dimethyl-1,3,4,6,7,8-hexahydro-2H-pyrimido[1,2-a]pyrimidin

0,5 g 2,4-Dimethyl-3,4-dihydro-2*H*-pyrimido[1,2-a]pyrimidin Hydroperchlorat wurden in essigsaurer Lösung mit Palladium auf Aktivkohle 8 h unter H₂-Zufuhr erwärmt. Anschließende Filtration, Entfernen des Lösungsmittels und Zugabe von Diethylether lieferte das 2,4-Dimethyl-1,3,4,6,7,8-hexahydro-2*H-*pyrimido[1,2-a]pyrimidin Hydroacetat als farblose Kristalle, die aus Ethanol umkristallisiert wurden.
Ausbeute: 0,37 g
Fp. 101 °C
¹H-NMR (500 MHz, DMSO-d₆) [ppm] :
7,47 (s, 1H); 7,09 (s, 1H); 3,50-3,55 (m, 1H); 3,43-3,39 (m, 1H); 3,35-3,21 (m, 3H); 3,05-3,03 (m, 1H); 2,11 (m, 1H); 1,95-1,91 (m, 1H); 1,78-1,71 (m, 1H); 1,37-1,30 (quar, 1H); 1,24 (d, 3H); 1,14 (d, 3H)

Die Freisetzung des 2,4-Dimethyl-1,3,4,6,7,8-hexahydro-2H-pyrimido[1,2-a]pyrimidins erfolgte in alkalischer Ethanollösung.
Ausbeute: 0,1 g
Fp. 133 °C
¹H-NMR (500 MHz, DMSO-d₆) [ppm] :
3,24-3,16 (m, 3H); 3,16-3,14 (m, 1H); 3,09-2,93 (m, 1H); 2,86-2,83 (m, 1H); 1,89-1,85 (m, 1H); 1,77-1,73 (m, 1H); 1,65-1,58 (m, 1H); 1,17-1,10 (m, 4H); 0,97 (d, 3H)
MS: m/z = 167 [M]⁺

### Beispiel 3:

### 1. Benzimidazo[1,2-a]pyrimidin Hydroperchlorat

Die Herstellung erfolgte nach einer in der Literatur beschriebenen Methode (M. Künstlinger, E. Breitmaier, Synthesis 1983 (2), 161-162). Davon abweichend wurde das Produkt durch Zugabe von Perchlorsäure als Benzimidazo[1,2-a]pyrimidin Hydroperchlorat isoliert.
Fp. 245 °C
¹H-NMR (500 MHz, DMSO-d₆) [ppm] :
9,98 (dd, 1H); 9,26 (dd, 1H); 8,60 (d, 1H); 7,95 (d, 1H); 7,86-7,81 (m, 2H); 7,73 (t, 1H)

### 2. 1,2,3,4-Tetrahydro-benzimidazo[1,2-a]pyrimidin

0,602 g Benzimidazo[1,2-a]pyrimidin Hydroperchlorat wurden in salzsaurer Lösung (2 M HCl) mit Palladium auf Aktivkohle 9 h unter H₂-Zufuhr erwärmt. Anschließende Filtration, Entfernen des Lösungsmittels und Zugabe von Diethylether lieferte das 1,2,3,4-Tetrahydro-benzimidazo[1,2-a]pyrimidin Hydrochlorid als farblose Kristalle, die aus Ethanol umkristallisiert wurden.
Ausbeute: 0,18 g
Fp. 212 °C
¹H-NMR (500 MHz, DMSO-d₆) [ppm] :
12,62 (s, 1H); 9,18 (s, 1H); 7,47 (m, 1H); 7,38 (m, 1H); 7,27 (m, 1H); 4,08 (t, 2H); 3,48 (m, 2H); 2,14 (quint., 2H)
MS: m/z = 174 [M]⁺

Die Freisetzung des 1,2,3,4-Tetrahydro-benzimidazo[1,2-a]pyrimidins erfolgte in alkalischer Ethanollösung.
Fp. 190°C
¹H-NMR (500 MHz, DMSO-d₆) [ppm] :
7,13-7,07 (m, 3H); 6,92 (m, 1H); 6,85 (m, 1H); 3,96 (t, 2H); 3,31 (t, 2H); 2,03 (quint., 2H)
MS: m/z = 173 [M]⁺

### Allgemeine Synthese der Komplexe des Typs M₂L₄

MCl₄ (WCl₄, 1,00 g, 3,07 mmol), mindestens 2 Äquivalente des jeweiligen Liganden (9,21 mmol) und Kalium im Überschuss (ca. 1 g) werden in 50 mL THF zum Rückfluss erhitzt. Danach lässt man abkühlen und filtriert die Mutterlauge ab. Das Filtrat wird zur Trockene eingeengt und mit Toluol extrahiert. Das Produkt wird mit Hexan als brauner Feststoff gefällt, durch Filtration isoliert und im Hochvakuum getrocknet. Ausbeuten um 30%.

### Beispiel 4:

### Tetrakis[tetrahydro-imidazo[1,2-a]pyrimidinato]diwolfram-II

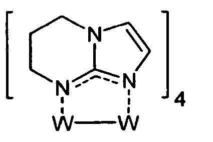

Synthese wie oben beschrieben mit 1,13g des Liganden 5,6,7,8-Tetrahydro-imidazo[1,2-a]pyrimidin.
¹H-NMR (500 MHz, C₆D₆) [ppm] :
6,7-6,2 (br, 2H); 3,8-3,3 (br, 4H); 1,9-1,3 (br, 2H).

### Beispiel 5:

### Tetrakis[dimethyl-1,3,4,6,7,8-hexahydro-2H-pyrimido-1,2-a]pyrimidinato]diwolfram-II

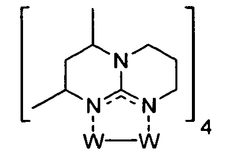

Synthese wie oben beschrieben mit 1,54g des Liganden 2,4-Dimethyl-1,3,4,6,7,8-hexahydro-2*H*-pyrimido-[1,2-*a*]pyrimidin.
¹H-NMR (500 MHz, C₆D₆) [ppm] :
3,5-2,6 (br, 4H); 2,0-1,3 (br, 4H); 1,3-0,9 (br, 6H).
ESI-MS: m/z = 184 [M⁺ + 3 OH].

### Beispiel 6:

### Tetrakis[tetrahydrobenzo[4,5]imidazo[1,2]a]pyrimidinato]diwolfram-II

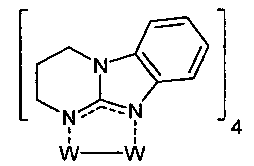

Synthese wie oben beschrieben mit 1,54g des Liganden 1,2,3,4-Tetrahydro-benzimidazo[1,2-a]pyrimidin.
In Abwandlung der allgemeinen Synthesevorschrift wird dieses Produkt aus der Mutterlauge mit Hexan gefällt. Der isolierte Feststoff ist nicht in Toluol löslich.
¹H-NMR (500 MHz, THF-d8) [ppm]:
6,60 (m, br, 1H); 6,55 (m, br, 1H); 6,40 (m, br, 1H); 6,34 (m, br, 1H); 3,72 (br, 2H); 3,42 (br, 2H); 1.77 (br, 2H).

### Matrixmaterialien

In der vorliegenden Erfindung werden geeignete n-Dotanden für organische halbleitende Materialien wie Elektronentransportmaterialien beschrieben, wie sie üblicherweise in elektronischen Bauelementen, einschließlich optoelektronischen Bauelementen, wie beispielsweise OLEDs, Feldeffekttransistoren oder organischen Solarzellen, verwendet werden. Die halbleitenden Materialien sind vorzugsweise intrinsisch elektronenleitend.

Das Matrixmaterial kann teilweise (> 10 oder > 25 Gew.-%) oder im Wesentlichen (> 50 Gew.-% oder > 75 Gew.-%)) oder vollständig bestehen aus einem Metallphthalocyanin-Komplex, einem Buckminster-Fulleren, gegebenenfalls auch einem Porphyrin-Komplex, insbesondere Metallporphyrinkomplex, einer Oligothiophen-, Oligophenyl-, Oligophenylenvinylen- oder Oligofluoren-Verbindung, wobei das Oligomere vorzugsweise 2-500 oder mehr, vorzugsweise 2-100 oder 2-50 oder 2-10 monomere Einheiten umfasst. Gegebenenfalls kann das Oligomer auch > 4, > 6 oder > 10 oder mehr monomere Einheiten umfassen, insbesondere auch für die oben angegebenen Bereiche, also beispielsweise 4 oder 6-10 monomere Einheiten, 6 oder 10-100 monomere Einheiten oder 10-500 monomere Einheiten. Die Monomere bzw. Oligomere können substituiert oder unsubstituiert sein, wobei auch Block- oder Mischpolymerisate aus den genannten Oligomeren vorliegen können. Die Matrix kann auch eine Mischung von Oligomeren mit verschiedenen Kettenlängen sein, wie es für gewöhnliche Polymerschichten der Fall ist.

Das Matrixmaterial kann auch eine Verbindung mit einer Triarylamin-Einheit oder eine Spiro-Bifluoren-Verbindung sein. Die genannten Matrixmaterialien können auch in Kombination miteinander vorliegen, gegebenenfalls auch in Kombination mit anderen Matrixmaterialien. Die Matrixmaterialien können elektronenschiebende Substituenten wie Alkyl- oder Alkoxy-Reste aufweisen, die eine verminderte Ionisierungsenergie aufweisen oder die Ionisierungsenergie des Matrixmaterials vermindern.

Die als Matrixmaterial eingesetzten Metallphthalocyaninkomplexe oder Porphyrinkomplexe können ein Hauptgruppenmetallatom oder Nebengruppenmetallatom aufweisen. Das Metallatom Me kann jeweils 4-, 5- oder 6-fach koordiniert sein, beispielsweise in Form von Oxo- (Me=O), Dioxo- (O=Me=O), Imin-, Diimin-, Hydroxo-, Dihydroxo-, Amino- oder Diaminokomplexen, ohne hierauf beschränkt zu sein. Der Phthalocyaninkomplex oder Porphyrinkomplex kann jeweils teilweise hydriert sein, wobei jedoch vorzugsweise das mesomere Ringsystem nicht gestört wird. Die Phthalocyaninkomplexe können als Zentralatom beispielsweise Magnesium, Zink, Eisen, Nickel, Kobalt, Magnesium, Kupfer oder Vanadyl (= VO) enthalten. Die gleichen oder andere Metallatome bzw. Oxometallatome können im Falle von Porphyrinkomplexen vorliegen.

Als n-dotierbare Matrixmaterialen können auch eingesetzt werden Quinolinatokomplexe, beispielsweise des Aluminiums oder anderer Hauptgruppenmetalle, wobei die der Quinolinatoligand auch substituiert sein kann. Insbesondere kann das Matrixmaterial Tris(8-hydroxy-quinolinato)-aluminium sein. Auch andere Aluminiumkomplexe mit O und/oder N Donoratomen können gegebenenfalls eingesetzt werden.

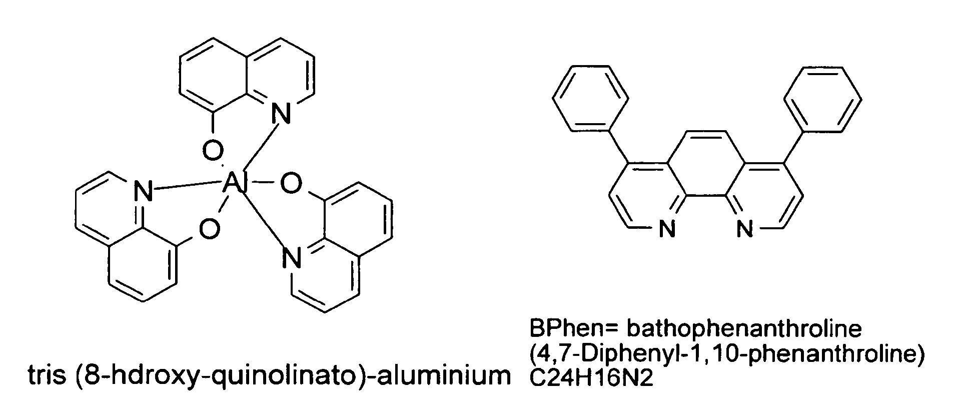

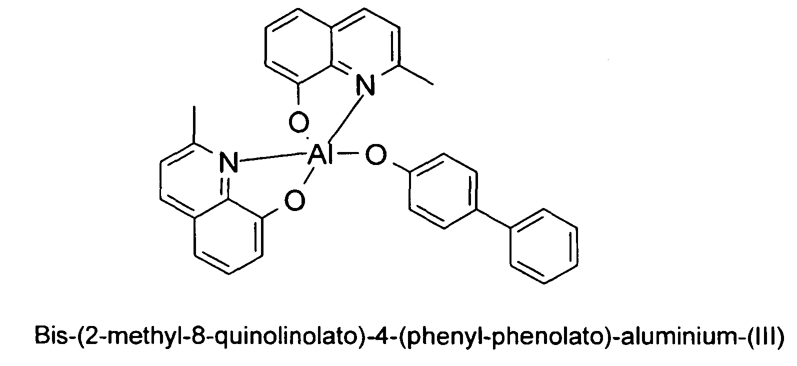

Die Quinolinatokomplexe können beispielsweise einen, zwei oder drei Quinolinatoliganden enthalten, wobei die anderen Liganden vorzugsweise mit O und/oder N-Donoratomen an das Zentralatom komplexieren, wie beispielsweise obenstehender A1-Komplex.

Als Matrixmaterial können auch Phenanthroline eingesetzt werden, die substituiert oder unsubstituiert sein können, insbesondere Aryl-substituiert, beispielsweise Phenyl- oder Naphthyl-substituiert. Insbesondere kann Bphen als Matrixmaterial eingesetzt werden.

Als Matrixmaterial können auch Heteroaromaten wie insbesondere Triazole eingesetzt werden, gegebenenfalls auch Pyrrole, Imidazole, Triazole, Pyridine, Pyrimidine, Pyridazine und dergleichen. Die Heteroaromaten sind vorzugsweise substituiert, insbesondere Aryl-substituiert, beispielsweise Phenyl- oder Naphthyl-substituiert. Insbesondere kann untenstehendes Triazol als Matrixmaterial eingesetzt werden.

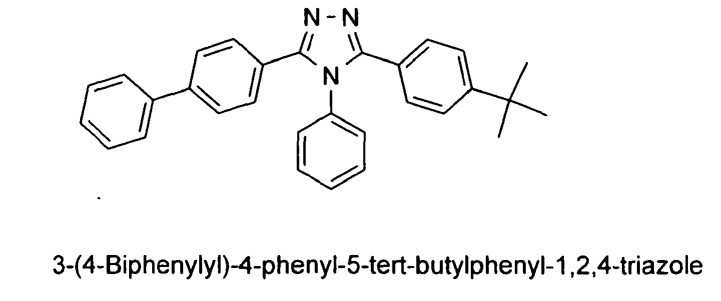

Vorzugsweise besteht das verwendete Matrixmaterial vollständig aus einem Metallphthalocyanin-Komplex, insbesondere ZnPc, einem Porphyrin-Komplex, oder einem Buckminster-Fulleren, insbesondere Fulleren C60.

Es versteht sich, dass die genannten Matrixmaterialien auch untereinander oder mit anderen Materialien gemischt im Rahmen der Erfindung einsetzbar sind. Es versteht sich, dass auch geeignete andere organische Matrixmaterialien verwendet werden können, die halbleitende Eigenschaften aufweisen.

### Dotierungskonzentration

Die Erfindung betrifft ferner ein organisches halbleitendes Material enthaltend einen erfindungsgemäßen Metallkomplex als n-Dotanden. Vorzugsweise liegt der Dotand in einer Dotierungskonzentration von ≤ 1:1 zu dem Matrixmolekül bzw. der monomeren Einheit eines polymeren Matrixmoleküls vor, vorzugsweise in einer Dotierungskonzentration von 1:2 oder kleiner, besonders bevorzugt von 1:5 oder kleiner oder 1:10 oder kleiner. Die Dotierungskonzentration kann in dem Bereich von 1:1 bis 1:100.000 oder kleiner, insbesondere in dem Bereich von 1:5 bis 10.000 oder 1:10 bis 1.000 liegen, beispielsweise in dem Bereich von 1:10 bis 1:100 oder 1:25 bis 1:50, ohne hierauf beschränkt zu sein.

### Durchführung der Dotierung

Die Dotierung des jeweiligen Matrixmaterials mit den erfindungsgemäß zu verwendenden n-Dotanden kann durch eines oder eine Kombination der folgenden Verfahren hergestellt wird:
a) Mischverdampfung im Vakuum mit einer Quelle für das Matrixmaterial und einer für den Dotanden.
b) Sequentielles Deponieren des Matrixmaterials und des n-Dotanden auf einem Substrat mit anschliessender Eindiffusion des Dotanden, insbesondere durch thermische Behandlung
c) Dotierung einer Matrixschicht durch eine Lösung von n-Dotanden mit anschliessendem Verdampfen des Lösungsmittels, insbesondere durch thermische Behandlung
d) Oberflächendotierung einer Matrixmaterialschicht durch eine oberflächlich aufgebrachte Schicht von Dotanden
e) Herstellung einer Lösung von Matrixmolekülen und Dotanden und anschließende Herstellung einer Schicht aus dieser Lösung mittels konventioneller Methoden wie beispielsweise Verdampfen des Lösungsmittels oder Aufschleudern

Die Dotierung kann gegebenenfalls auch derart erfolgen, dass der Dotand aus einer Precursor-Verbindung heraus verdampft wird, die beim Erhitzen und/oder Bestrahlung den Dotanden freisetzt. Als Precursor-Verbindung kann beispielsweise eine Distickstoffverbindung oder dergleichen eingesetzt werden, die bei der Freisetzung des Dotanden, Stickstoff oder dergleichen abspaltet, wobei auch andere geeignete Precursor einsetzbar sind, wie beispielsweise Salze, z.B. Halogenide, oder dergleichen. Die Bestrahlung kann mittels elektromagnetischer Strahlung, insbesondere sichtbarem Licht, UV-Licht oder IR-Licht erfolgen, beispielsweise jeweils Laserlicht, oder auch durch andere Strahlungsarten. Durch die Bestrahlung kann im wesentlichen die zur Verdampfung notwendige Wärme bereitgestellt werden, es kann auch gezielt in bestimmte Banden der zu verdampfenden Verbindungen bzw. Precursor oder Verbindungskomplexe wie Charge-Transfer-Komplexe eingestrahlt werden, um beispielsweise durch Überführung in angeregte Zustände die Verdampfung der Verbindungen durch Dissoziation der Komplexe zu erleichtern. Der Komplex kann aber insbesondere auch ausreichend stabil sein, um unter den gegebenen Bedingungen undissoziiert zu verdampfen oder auf das Substrat aufgebracht zu werden. Es versteht sich, dass auch andere geeignete Verfahren zur Durchführung der Dotierung eingesetzt werden können.

Auf diese Weise können somit n-dotierte Schichten von organischen Halbleitern hergestellt werden, die vielfältig einsetzbar sind.

### Halbleitende Schicht

Mittels der verwendeten Metallkomplexe können halbleitende Schichten erzeugt werden, die gegebenenfalls aber auch linienförmig ausgebildet sind, wie z.B. als Leitfähigkeitspfade, Kontakte oder dergleichen. Die Metallkomplexe können hierbei als n-Dotanden zusammen mit einer anderen Verbindung, die als Matrixmaterial fungieren kann, eingesetzt werden, wobei das Dotierungsverhältns 1 : 1 oder kleiner sein kann. Der verwendete Metallkomplexe kann zu der jeweils anderen Verbindung bzw. Komponente aber auch in höheren Anteilen vorliegen, so dass das Verhältnis Metallkomplex : Verbindung im Verhältnis > 1 : 1 liegen kann, beispielsweise im Verhältnis ≥ 2 : 1, ≥ 5 : 1, ≥ 10 : 1 oder ≥ 20 : 1 oder höher. Die jeweils andere Komponente kann eine solche sein, wie sie als Matrixmaterial im Falle der Herstellung dotierter Schichten eingesetzt werden kann, ohne hierauf beschränkt zu sein. Gegebenenfalls kann der verwendete Metallkomplex auch im wesentlich in reiner Form vorliegen, beispielsweise als reine Schicht.
Der einen Metallkomplex enthaltende oder im wesentlichen oder vollständig aus diesem bestehende Bereich kann insbesondere mit einem organischen halbleitenden Material und/oder einem anorganischen halbleitenden Material elektrisch stromleitend kontaktiert sein, beispielsweise auf einem derartigen Substrat angeordnet sein.

Vorzugsweise werden die genannten Metallkomplexe als n-Dotanden eingesetzt, z.B. in einem Verhältnis ≤ 1 : 1 oder ≤ 1 : 2, oder wie weiter oben näher ausgeführt. Mittels der als n-Dotanden eingesetzten Metallkomplexen können beispielsweise bei der Verwendung von Fulleren C₆₀ als Matrix halbleitende Schichten mit Leitfähigkeiten bei Raumtemperatur in dem Bereich von 10⁻⁵ S/cm oder höher erzielt werden, beispielsweise von 10⁻³ S/cm oder höher, beispielsweise von 10⁻¹ S/cm. Bei der Verwendung von Phthalocyanin-Zink als Matrix wurde eine Leitfähigkeit von höher 10⁻⁸ S/cm erzielt, beispielsweise 10⁻⁶ S/cm. Bisher war es nicht möglich, diese Matrix mit organischen Donoren zu dotieren, da das Reduktionspotential der Matrix zu gering ist. Die Leitfähigkeit von undotiertem Phthalocyanin Zink beträgt hingegen maximal 10⁻¹⁰ S/cm.

Es versteht sich, dass die Schicht oder das Gebilde mit erfindungsgemäßem Metallkomplex jeweils einen oder mehrere verschiedene derartige Komplexe enthalten kann.

### Elektronisches Bauelement

Unter Verwendung der organischen Verbindungen zur Herstellung n-dotierter organischer halbleitender Materialien, die insbesondere in Form von Schichten oder elektrischen Leitungspfaden angeordnet sein können, können eine Vielzahl elektronischer Bauelemente oder diese enthaltende Einrichtungen mit einer n-dotierten organischen Halbleiterschicht hergestellt sein, die somit von der Erfindung mit umfasst werden. Im Sinne der Erfindung werden von dem Begriff "elektronische Bauelemente" auch optoelektronische Bauelemente mit umfasst. Durch die Verbindungen können die elektronischen Eigenschaften eines elektronisch funktionell wirksamen Bereichs des Bauelementes wie dessen elektrische Leitfähigkeit, lichtemittierende Eigenschaften oder dergleichen vorteilhaft verändert werden. So kann durch die Metallkomplexe als n-Dotanden die Leitfähigkeit der dotierten Schichten und/oder die Verbesserung der Ladungsträgerinjektion von Kontakten in die dotierte Schicht verbessert werden.

Die Erfindung umfasst insbesondere organische lichtemittierende Dioden (OLED), organische Solarzellen, organische Dioden, insbesondere solche mit hohem Gleichrichtungsverhältnis wie 10³-10⁷, vorzugsweise 10⁴-10⁷ oder 10⁵-10⁷, und organischen Feldeffekttransistoren, die mittels der neutralen Metallkomplexe nach der Erfindung hergestellt sind.

In dem elektronischen Bauelement kann eine n-dotierte Schicht auf Basis eines organischen Matrixmaterials beispielsweise in folgenden Schichtstrukturen vorliegen, wobei vorzugsweise die Basismaterialien oder Matrixmaterialien der einzelnen Schichten jeweils organisch sind:
M-i-n: Metall-Isolator-n-dotierter Halbleiter, wobei die Schicht M den Metallgrundkontakt bildet und beispielsweise ITO, Au, Ag, Al usw. sein kann. Der Deckkontakt bildet mit der n-dotierten Schicht einen ohmschen Kontakt und kann beispielsweise aus A1 bestehen. Die Schicht "i" steht für eine undotierte Schicht.
n-i-M: es gelten die Ausführungen zur M-i-n Struktur, im Unterschied hierzu ist jedoch der ohmsche Kontakt auf dem Substrat vorgesehen.
p-i-n: p-dotierter Halbleiter-Isolator-n-dotierter Halbleiter, n-i-p: n-dotierter Halbleiter-Isolator-p-dotierter Halbleiter, "i" ist wiederum eine undotierte Schicht, "p" ist eine p-dotierte Schicht. Die Kontaktmaterialien sind hier löcherinjizierend, wobei p-seitig beispielsweise eine Schicht oder ein Kontakt aus ITO oder Au vorgesehen sein kann, oder elektroneninjizierend, wobei n-seitig eine Schicht oder ein Kontakt aus ITO, Al oder Ag vorgesehen sein kann.

In obigen Strukturen kann im Bedarfsfall auch die i-Schicht ausgelassen werden, wodurch Schichtenabfolgen mit p-n oder n-p-Übergängen erhalten werden können.

Die Verwendung der Dotanden ist jedoch auf die oben genannten Ausführungsbeispiele nicht beschränkt, insbesondere können die Schichtstrukturen durch Einführung zusätzlicher geeigneter Schichten ergänzt bzw. modifiziert werden. Insbesondere können jeweils OLEDs mit derartigen Schichtabfolgen, insbesondere mit pin- oder mit einer dazu inversen Struktur, mit n-Dotanden aufgebaut werden.

Mit Hilfe der n-Dotanden können insbesondere organische Dioden vom Typ Metall-Isolator-n-dotierte Halbleiter (min) oder auch gegebenenfalls vom pin-Typ hergestellt werden, beispielsweise auf der Basis von Phthalocyanin-Zink. Diese Dioden zeigen ein Rektifizierungsverhältnis von 10⁵ und höher. Ferner können unter Verwendung der Dotanden elektronische Bauelemente mit p-n-Übergängen erzeugt werden, wobei für die p- und die n-dotierte Seite jeweils dasselbe Halbleitermaterial verwendet wird (Homop-n-Übergang) und wobei für das n-dotierte Halbleitermaterial ein Metallkomplex eingesetzt wird. Derartige Bauteile sind von der Erfindung somit mit umfasst.

Die Metallkomplexe können in den elektronischen Bauelementen aber auch in Schichten, Leitfähigkeitspfaden, Punktkontakten oder dergleichen eingesetzt werden, wenn diese gegenüber einer anderen Komponente überwiegen, beispielsweise als Injektionsschicht in reiner oder im wesentlichen reiner Form.

Der vorgelegte Metallkomplex wird gleichzeitig mit dem Matrixmaterial verdampft. Gemäß dem Ausführungsbeispiel ist das Matrixmaterial jeweils Phthalocyanin-Zink oder Fulleren C₆₀. Der N-Dotand und Matrixmaterial können derart verdampft werden, dass die auf einem Substrat in einer Vakuumverdampfungsanlage niedergeschlagene Schicht ein Dotierungsverhältnis von n-Dotand zu Matrixmaterial von 1:10 aufweist.

Die jeweils mit dem n-Dotanden dotierte Schicht des organischen Halbleitermaterials ist auf einer ITO-Schicht (Indiumzinnoxid) aufgebracht, welche auf einem Glassubstrat angeordnet ist. Nach Aufbringung der n-dotierten organischen Halbleiterschicht wird eine Metallkathode aufgebracht, beispielsweise durch Aufdampfung eines geeigneten Metalls, um eine organische Leuchtdiode herzustellen. Es versteht sich, dass die organische Leuchtdiode auch einen sogenannten invertierten Schichtaufbau haben kann, wobei die Schichtenabfolge ist: Glassubstrat - Metallkathode - n-dotierte organische Schicht - transparente leitende Deckschicht (beispielsweise ITO). Es versteht sich, dass je nach Anwendungsfall zwischen den einzelnen genannten Schichten weitere Schichten vorgesehen sein können.

## Patentansprüche

1. Metallkomplex zur Dotierung eines organischen halbleitenden Matrixmaterials, der eine Struktur aufweist, die ausgewählt ist aus der Gruppe von: 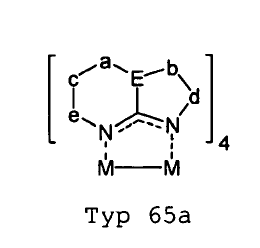 wobei .
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit Cₗ-C₂₀, Alkenyl mit C₁-C₂₀, Alkinyl mit C₁-C₂₀,Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NR₂ oder -OR, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können,
- wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente 0, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; 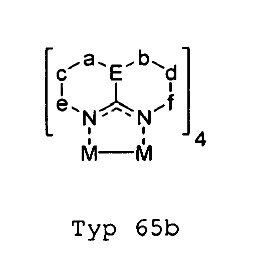
wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, wobei hiervon die Struktur 65b mit R₁, R₂, R₃, R₄, R₅, R₆, R₇, R₈, R₉, R₁₀, R₁₁ und R₁₂ = H ausgenommen ist, oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall, vorzugsweise W oder Mo ist; 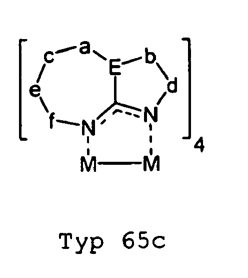 wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit Cᵢ-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente 0, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann,
- wobei das Metall M ein Übergangsmetall ist, vorzugsweise W oder Mo; oder 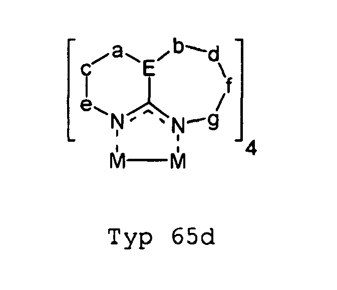
- wobei die Strukturelemente a-g die Bedeutung: a = -CR₁R₂-, b = -CR₃R₄-, c = -CR₅R₆-, d = -CR₇R₈-, e = -CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente O, S, Se, N, enthalten kann,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann
- wobei das Metall M ein Übergangsmetall ist, vorzugsweise W oder Mo.

2. Verfahren zur Herstellung eines Metallkomplexes nach Anspruch 1, welches die Schritte umfaßt:
(a) Umsetzen eines anorganischen Metallsalzes des Zentralatoms M mit einer freien Base eines Liganden in einem organischen Lösungsmittel in Gegenwart eines Reduktionsmittels und Erhitzen zum Rückfluß,
(b) Isolierung des erhaltenen Produkts nach der Umsetzung und Trocknung, wobei der Ligand ausgewählt wird aus der Gruppe bestehend aus 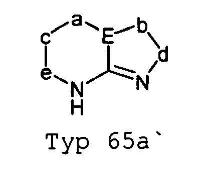 wobei
- die Strukturelemente a-e die Bedeutung: a = -CR₁R₂-, b = -CR₃R₄-, c = -CR₅R₆-, d = -CR₇R₈- und e = -CR₉R₁₀- haben können, wobei R₁, R₂, R₃, R₄, R₅, R₆, R₇, R₈, R₉ und R₁₀ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉ = H und R₂, R₄, R₆, R₈, R₁₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NR₂ oder -OR, wobei hiervon die Struktur 65a' mit R₁ bis R₁₀ = H ausgenommen ist, wobei hiervon die Struktur 65a' mit R₁ und R₂ = Aryl ausgenommen ist, wobei in der Struktur 65a' R₁ und R₁₀ stets H sind, oder
- wahlweise a oder b oder e oder d NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- bei c C durch Si ersetzt ist,
- wobei die Bindungen b-d und c-e oder b-d und a-c gleichzeitig oder unabhängig voneinander ungesättigt sein können, wobei die Bindungen b-d, a-c und c-e gleichzeitig oder unabhängig voneinander Teil eines gesättigten oder ungesättigten Ringsystems sein können, welches auch die Heteroelemente O, S, Se, N, P, Si, Ge, Sn enthalten kann, wobei hiervon der Ligand mit c-e = cyclohexyl und cylcohexenyl ausgenommen ist,oder
- wobei die Bindungen b-d, a-c und c-e gleichzeitig oder unabhängig voneinander Teil eines aromatischen oder kondensierten aromatischen Ringsystems sein können, welches auch die Heteroelemente O, S, Se, N, enthalten kann, wobei hiervon der Ligand bei dem b-d, a-c und c-e Bestandteil von Benzen sind ausgenommen ist,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann, 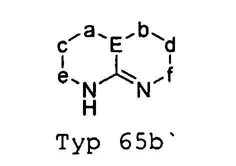 wobei
- die Strukturelemente a-f die Bedeutung: a= -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sind, vorzugsweise sind R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, wobei hiervon die Struktur 65b mit R₁, R₂, R₃, R₄, R₅, R₆, R₇, R₈, R₉, R₁₀, R₁₁ und R₁₂ = H ausgenommen ist, wobei hiervon der Ligand mit R₉, R₁₀, R₁₁, und R₁₂ = Phenyl, Methyl, Allyl, RSCH₂- und ROCH₂- ausgenommen ist, wobei hiervon der Ligand mit R₉ = Phenyl, R₁₀ = H, R₁₁ = Phenyl, R₁₂ = H ausgenommen ist, wobei hiervon der Ligand mit R₁ = Phenyl ausgenommen ist, wobei hiervon der Ligand mit R₅, R₆, R₇, R₈ = Phenoxy ausgenommen ist oder
- bei den Strukturelementen c und/oder d C durch Si ersetzt sein kann, oder
- wahlweise a oder b oder e oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f ungesättigt sein können,
- wobei die Bindungen a-c, b-d, c-e und d-f Teil eines gesättigten oder ungesättigten Ringsystems sein können, welches auch die Heteroelemente O, S, Se, N, P, Si, Ge, Sn enthalten kann, oder
- die Bindungen a-c, b-d, c-e und d-f Teil eines aromatischen oder kondensierten aromatischen Ringsystems sein können, welches auch die Heteroelemente O, S, Se, N, enthalten kann, wobei hiervon der Ligand bei dem a-c, b-d, c-e und d-f Bestandteil von Benzen sind ausgenommen ist,
- wobei das Atom E ein Hauptgruppenelement ist, bevorzugt ausgewählt aus der Gruppe N, P, As, Sb, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, ausgenommen hiervon ist der Ligand mit a-E-b = Bestandteil von cyclopentyl sowie pyranyl mit R₉ bis R₁₂ = alkyl, oder
- das Strukturelement a-E-b wahlweise Bestandteil eines aromatischen Ringsystems sein kann, welches auch die Heteroelemente O, S, Se, N, enthalten kann, 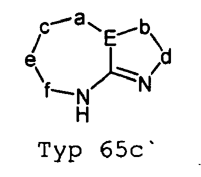 wobei
- die Strukturelemente a-f die Bedeutung: a = -CR₁R₂-, b = -CR₃R₄-, c = -CR₅R₆-, d = -CR₇R₈-, e = -CR₉R₁₀- und f = CR₁₁R₁₂ haben können, wobei R₁, R₂, R₃, R₄, R₅, R₆, R₇, R₈, R₉, R₁₀, R₁₁ und R₁₂ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁ = H und R₂, R₄, R₆, R₈, R₁₀, R₁₂ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, wobei hiervon der Ligand mit R₁ bis R₁₂ = H ausgenommen ist, oder
- bei c oder e C durch Si ersetzt sein kann, oder
- wahlweise a oder b oder d oder f NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und d oder b und f NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, e-f und b-d, aber nicht gleichzeitig a-c, c-e und e-f und nicht gleichzeitig a-c und c-e und nicht gleichzeitig c-e und e-f ungesättigt sein können,
- wobei die Bindungen a-c, c-e, e-f und b-d Teil eines gesättigten oder ungesättigten Ringsystems sein können, welches auch die Heteroelemente O, S, Se, N, P, Si, Ge, Sn enthalten kann, oder
- die Bindungen a-c, c-e, e-f und b-d Teil eines aromatischen oder kondensierten aromatischen Ringsystems sein können, welches auch die Heteroelemente O, S, Se, N, enthalten kann, ausgenommen hiervon ist der Ligand mit E=N und gleichzeitig e-f und/oder b-d Teil von Benzen oder Naphthalen, ausgenommen hiervon ist der Ligand mit E= N und gleichzeitig R₇ = R₈ = Phenyl, ausgenommen hiervon ist der Ligand mit E=N und R₃ = Phenyl, Benzyl
- wobei das Atom E ein Hauptgruppenelement ist, bevorzugt ausgewählt aus der Gruppe N, P, As, Sb, ohne auf diese beschränkt zu sein, wobei hiervon der Ligand mit E=N und gleichzeitig dem Siebenring mit mehr als einer ungesättigten Bindung ausgenommen ist
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann, 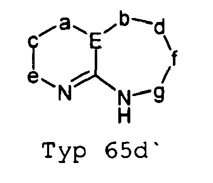 wobei
- die Strukturelemente a-g die Bedeutung: a = -CR₁R₂-, b = -CR₃R₄-, c = -CR₅R₆-, d = -CR₇R₈-, e = -CR₉R₁₀-, f = CR₁₁R₁₂ und g = CR₁₃R₁₄ haben können, wobei R₁, R₂, R₃, R₄, R₅, R₆, R₇, R₈, R₉, R₁₀, R₁₁, R₁₂, R₁₃ und R₁₄ gleichzeitig oder unabhängig voneinander H, Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR sein kann; vorzugsweise ist R₁, R₃, R₅, R₇, R₉, R₁₁, R₁₃ = H und R₂, R₄, R₆, R₈, R₁₀, R₁₂, R₁₄ = Alkyl mit C₁-C₂₀, Cycloalkyl mit C₁-C₂₀, Alkenyl mit C₁-C₂₀, Alkinyl mit C₁-C₂₀, Aryl, Heteroaryl, - NR₂ oder -OR, oder
- bei c, d und f, jedoch nicht d und f gleichzeitig, C durch Si ersetzt sein kann, oder
- wahlweise a oder b oder e oder g NR sein kann mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und g oder b und e NR sein können mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, c-e, b-d, d-f und f-g, aber nicht gleichzeitig a-c und c-e, und nicht gleichzeitig b-d, d-f und f-g, und nicht gleichzeitig b-d und d-f, und nicht gleichzeitig d-f und f-g, ungesättigt sein können,ausgenommen ist der Ligand, bei dem b-d und f-g gleichzeitig ungesättigt sind,
- wobei die Bindungen a-c, c-e, b-d, d-f und f-g Teil eines gesättigten oder ungesättigten Ringsystems sein können, welches auch die Heteroelemente O, S, Se, N, P, Si, Ge, Sn enthalten kann, oder
- die Bindungen a-c, c-e, b-d, d-f und f-g Teil eines aromatischen oder kondensierten aromatischen Ringsystems sein können, welches auch die Heteroelemente 0, S, Se, N, enthalten kann,ausgenommen ist der Ligand, bei dem c-e und f-g gleichzeitig Teil eines Benzenringes sind
- wobei das Atom E ein Hauptgruppenelement ist, bevorzugt ausgewählt aus der Gruppe B, C, N, O, Si, P, S, As, Se, Sb, Te, besonders bevorzugt ausgewählt aus der Gruppe S, Se, N, P, ohne auf diese beschränkt zu sein,
- wobei das Strukturelement a-E-b wahlweise Bestandteil eines gesättigten oder ungesättigten Ringsystems sein kann, welches auch die Heteroelemente O, S, Se, N, P, Si, Ge, Sn enthalten kann, oder
- das Strukturelement a-E-b wahlweise Bestandteil eines aromatischen Ringsystems sein kann, welches auch die Heteroelemente O, S, Se, N, enthalten kann.

3. Verfahren nach Anspruch 2, **dadurch gekennzeichnet, daß** das Lösungsmittel Ether, ein aromatisches Lösungsmittel oder eine Mischung derselben ist.

4. Verfahren nach Anspruch 3, **dadurch gekennzeichnet, daß** der Ether Dialkylether, cyclischer Ether, cyclischer und/oder offenkettiger Polyether ist.

5. Verfahren nach einem der Ansprüche 2 bis 4, **dadurch gekennzeichnet, daß** das Reduktionsmittel ein unedles Metall ist.

6. Verfahren nach Anspruch 5, **dadurch gekennzeichnet, daß** das unedle Metall Natrium, Kalium und/oder Cäsium ist.

7. Verfahren nach einem der Ansprüche 2 bis 6, **dadurch gekennzeichnet, daß** die Isolierung durch Kristallisation, Ausfällen und/oder Sublimation erfolgt.

8. Halbleitendes Material mit einem Metallkomplex nach Anspruch 1 in Form einer elektrisch kontaktierbaren Schicht oder eines auf einem Substrat angeordneten elektrischen Leitungspfads.

9. Organisches halbleitendes Material enthaltend zumindest eine organische Matrixverbindung und einen n-Dotanden,
**dadurch gekennzeichnet, daß** der n-Dotand ein oder mehrere Metallkomplexe nach Anspruch 1 ist.

10. Organisches halbleitendes Material nach Anspruch 9, **dadurch gekennzeichnet, daß** das molare Dotierungsverhältnis von Dotand zu Matrixmolekül bzw. das Dotierungsverhältnis von Dotand zu monomeren Einheiten eines polymeren Matrixmoleküls zwischen 1:1 und 1:100000 beträgt.

11. Verfahren zur Herstellung eines organischen halbleitenden Materials enthaltend ein organisches Matrixmolekül und einen n-Dotanden, **dadurch gekennzeichnet, daß** als n-Dotand zumindest ein oder mehrere Metallkomplexe nach Anspruch 1 verwendet wird bzw. werden.

12. Elektronisches Bauelement mit einer n-dotierten organischen Halbleiterschicht, **dadurch gekennzeichnet, daß** der n-Dotand zumindest einer oder mehrere der Metallkomplexe nach Anspruch 1 ist.

13. Elektronisches Bauelement nach Anspruch 12 in Form einer organischen lichtemittierenden Diode (OLED), einer photovoltaischen Zelle, einer organischen Solarzelle, einer organischen Diode oder eines organischen Feldeffekttransistors, bei dem das mit zumindest einem Dotanden nach Anspruch 1 dotierte halbleitende organische Material einen elektronisch funktionell wirksamen Teil des elektronischen Bauelements darstellt.

14. Verwendung eines Metallkomplexes nach Anspruch 1 als eine Injektionsschicht in elektronischen Bauelementen.

## Claims

1. Metal complex for doping an organic semiconductive matrix material, said complex having a structure which is selected from the group of: 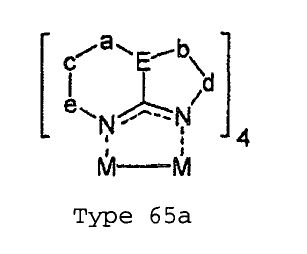 where
- the structural elements a-e may be defined as: a = -CR₁R₂-, b = -CR₃R₄-, c = -CR₅R₆-, d = -CR₇R₈- and e = -CR₉R₁₀-, where R₁, R₂, R₃, R₄, R₅, R₆, R₇, R₈, R₉ and R₁₀ are simultaneously or each independently H, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇ , R₉ = H, and R₂, R₄, R₆ , R₈, R₁₀ = alkyl with C₁-C₂₀, cycloalkyl with C₁-C₂₀, alkenyl with C₁-C₂₀, alkynyl with C₁-C₂₀, aryl, heteroaryl, -NR₂ or -OR, or
- optionally, a or b or e or d may be NR where R = alkyl with C₁-C₂₀, cycloalkyl with C₁-C₂₀, alkenyl with C₁-C₂₀, alkynyl with C₁-C₂₀, aryl, heteroaryl, or
- in c, C is replaced by Si,
- where the b-d and c-e or b-d and a-c bonds may simultaneously or each independently be unsaturated,
- where the b-d, a-c and c-e bonds may simultaneously or each independently be part of a saturated or unsaturated ring system which may also comprise the heteroelements 0, S, Se, N, P, Si, Ge, Sn, or
- where the b-d, a-c and c-e bonds may simultaneously or each independently be part of an aromatic or fused aromatic ring system which may also contain the heteroelements O, S, Se, N,
- where the E atom is a main group element, preferably selected from the group of N, P, As, Sb, without being restricted thereto,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements 0, S, Se, N,
- where the metal M is a transition metal, preferably W or Mo; 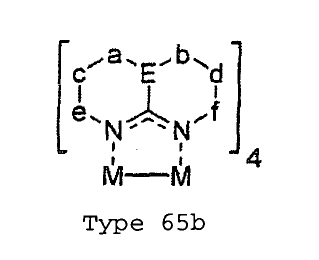 where
- the structural elements a-f may be defined as: a = -CR₁R₂-, b = -CR₃R₄-, c = -CR₅R₆-, d = -CR₇R₈-, e = -CR₉R₁₀- and f = -CR₁₁R₁₂-, where R₁, R₂, R₃, R₄, R₅, R₆, R₇, R₈, R₉, R₁₀, R₁₁ and R₁₂ are each hydrogen, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, Rg, R₁₁ = H, and R₂, R₄, R₆, R₈, R₁₀, R₁₂ = alkyl with C₁-C₂₀, cycloalkyl with C₁-C₂₀, alkenyl with C₁-C₂₀, alkynyl with C₁-C₂₀, aryl, heteroaryl, -NR₂ or -OR, excluding the structure 65b where R₁, R₂, R₃, R₄, R₅, R₆, R₇, R₈, R₉, R₁₀, R₁₁ and R₁₂ = H, or
- in the structural elements c and/or d, C may be replaced by Si, or
- optionally, a or b or e or f may be NR where R = alkyl with C₁-C₂₀, cycloalkyl with C₁-C₂₀, alkenyl with C₁-C₂₀, alkynyl with C₁-C₂₀, aryl, heteroaryl or
- optionally, a and f or b and e may be NR where R = alkyl with C₁-C₂₀, cycloalkyl with C₁-C₂₀, alkenyl with C₁-C₂₀, alkynyl with C₁-C₂₀, aryl, heteroaryl,
- where the a-c, b-d, c-e and d-f bonds, but not simultaneously a-c and c-e and not simultaneously b-d and d-f may be unsaturated,
- where the a-c, b-d, c-e and d-f bonds may be part of a saturated or unsaturated ring system which may also contain the heteroelements O, S, Se, N, P, Si, Ge, Sn, or
- the a-c, b-d, c-e and d-f bonds may be part of an aromatic or fused aromatic ring system which may also contain the heteroelements O, S, Se, N,
- where the E atom is a main group element, preferably selected from the group of N, P, As, Sb, without being restricted thereto,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements O, S, Se, N,
- where the metal M is a transition metal, preferably W or Mo; 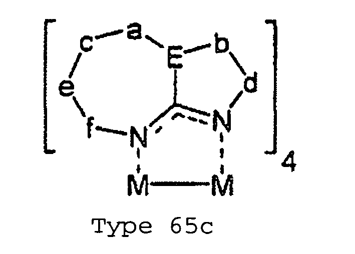 where
- the structural elements a-f may be defined as: a = -CR₁R₂-, b = -CR₃R₄-, c = -CR₅R₆-, d = -CR₇R₈-, e = -CR₉R₁₀- and f = -CR₁₁R₁₂-, where R₁, R₂, R₃, R₄, R₅, R₆, R₇, R₈, R₉, R₁₀, R₁₁ and R₁₂ may simultaneously or each independently be H, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, R₉, R₁₁= H, and R₂, R₄, R₆, R₈ , R₁₀, R₁₂ = alkyl with C₁-C₂₀, cycloalkyl with C₁-C₂₀, alkenyl with C₁-C₂₀, alkynyl with C₁-C₂₀, aryl, heteroaryl, -NR₂ or -OR, or
- in c or e, C may be replaced by Si, or
- optionally, a or b or d or f may be NR where R = alkyl with Cₗ-C₂₀, cycloalkyl with Cₗ-C₂₀, alkenyl with Cₗ-C₂₀, alkynyl with Cᵢ-C₂₀, aryl, heteroaryl, or
- optionally, a and d or b and f may be NR where R = alkyl with C₁-C₂₀, cycloalkyl with C₁-C₂₀, alkenyl with C₁-C₂₀, alkynyl with C₁-C₂₀, aryl, heteroaryl,
- where the a-c, c-e, e-f and b-d bonds, but not simultaneously a-c, c-e and e-f and not simultaneously a-c and c-e and not simultaneously c-e and e-f, may be unsaturated,
- where the a-c, c-e, e-f and b-d bonds may be part of a saturated or unsaturated ring system which may also contain the heteroelements O, S, Se, N, P, Si, Ge, Sn, or
- the a-c, c-e, e-f and b-d bonds may be part of an aromatic or fused aromatic ring system which may also contain the heteroelements O, S, Se, N,
- where the E atom is a main group element, preferably selected from the group of N, P, As, Sb, without being restricted thereto,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements O, S, Se, N,
- where the metal M is a transition metal, preferably W or Mo; or 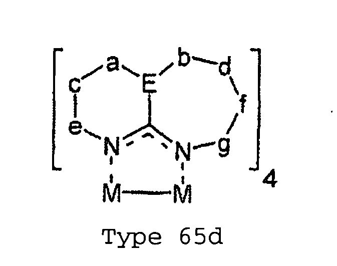
- where the structural elements a-g may be defined as: a = -CR₁R₂-, b = -CR₃R₄-, c = -CR₅R₆-, d = -CR₇R₈- e = -CR₉R₁₀-, f = -CR₁₁R₁₂- and g = -CR₁₃R₁₄-, where R₁, R₂, R₃, R₄ , R₅ , R₆, R₇, R₈, R₉ , R₁₀, R₁₁, R₁₂, R₁₃ and R₁₄ may simultaneously or each independently be H, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, R₉, R₁₁, R₁₃ = H, and R₂, R₄, R₆, R₈, R₁₀, R₁₂, R₁₄ = alkyl with C₁-C₂₀, cycloalkyl with C₁-C₂₀, alkenyl with C₁-C₂₀, alkynyl with C₁-C₂₀, aryl, heteroaryl, -NR₂ or -OR, or
- in c, d and f, but not d and f simultaneously, C may be replaced by Si, or
- optionally, a or b or e or g may be NR where R = alkyl with C₁-C₂₀, cycloalkyl with C₁-C₂₀, alkenyl with C₁-C₂₀, alkynyl with C₁-C₂₀, aryl, heteroaryl, or
- optionally, a and g or b and e may be NR where R = alkyl with C₁-C₂₀, cycloalkyl with C₁-C₂₀, alkenyl with C₁-C₂₀, alkynyl with C₁-C₂₀, aryl, heteroaryl,
- where the a-c, c-e, b-d, d-f and f-g bonds, but not simultaneously a-c and c-e, and not simultaneously b-d, d-f and f-g, and not simultaneously b-d and d-f, and not simultaneously d-f and f-g, may be unsaturated,
- where the a-c, c-e, b-d, d-f and f-g bonds may be part of a saturated or unsaturated ring system which may also contain the heteroelements O, S, Se, N, P, Si, Ge, Sn, or
- the a-c, c-e, b-d, d-f and f-g bonds may be part of an aromatic or fused aromatic ring system which may also contain the heteroelements O, S, Se, N,
- where the E atom is a main group element, preferably selected from the group of N, P, As, Sb, without being restricted thereto,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements O, S, Se, N,
- where the metal M is a transition metal, preferably W or Mo.

2. Process for preparing a metal complex according to Claim 1, which comprises the steps of:
(a) reacting an inorganic metal salt of the central atom M with a free base of a ligand in an organic solvent in the presence of a reducing agent and heating to reflux,
(b) isolating the resulting product after the reaction and drying, the ligand being selected from the group consisting of 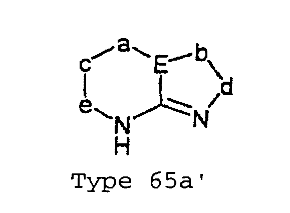 where
- the structural elements a-e may each be defined as: a = -CR₁R₂-, b = -CR₃R₄-, c = -CR₅R₆-, d = -CR₇R₈- and e = -CR₉R₁₀- , where R₁, R₂, R₃, R₄, R₅, R₆, R₇, R₈, R₉ and R₁₀ may simultaneously or each independently be H, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, R₉ = H, and R₂, R₄, R₆, R₈, R₁₀ = alkyl with C₁-C₂₀, cycloalkyl with C₁-C₂₀, alkenyl with C₁-C₂₀, alkynyl with C₁-C₂₀, aryl, heteroaryl, -NR₂ or -OR, excluding the structure 65a' where R₁ to R₁₀ = H, and excluding the structure 65a' where R₁ and R₂ = aryl, where R₁ and R₁₀ in the structure 65a' are always H, or
- optionally, a or b or e or d may be NR where R = alkyl with C₁-C₂₀, cycloalkyl with C₁-C₂₀, alkenyl with C₁-C₂₀, alkynyl with C₁-C₂₀, aryl, heteroaryl, or
- optionally, a and d or b and e may be NR where R = alkyl with C₁-C₂₀, cycloalkyl with C₁-C₂₀, alkenyl with C₁-C₂₀, alkynyl with C₁-C₂₀, aryl, heteroaryl, or
- in c, C is replaced by Si,
- where the b-d and c-e or b-d and a-c bonds may simultaneously or each independently be unsaturated, where the b-d, a-c and c-e bonds may simultaneously or each independently be part of a saturated or unsaturated ring system which may also comprise the heteroelements O, S, Se, N, P, Si, Ge, Sn, excluding the ligand where c-e = cyclohexyl and cyclohexenyl, or
- where the b-d, a-c and c-e bonds may simultaneously or each independently be part of an aromatic or fused aromatic ring system which may also contain the heteroelements 0, S, Se, N, excluding the ligand in which b-d, a-c and c-e are part of benzene, .
- where the E atom is a main group element, preferably selected from the group of N, P, As, Sb, without being restricted thereto,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements O, S, Se, N, 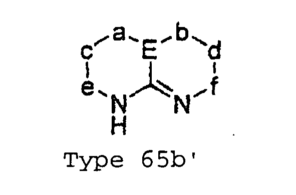 where
- the structural elements a-f may be defined as: a = -CR₁R₂-, b = -CR₃R₄-, c = -CR₅R₆-, d = -CR₇R₈-, e = -CR₉R₁₀- and f = -C₁₁R₁₂-, where R₁, R₂, R₃, R₄, R₅, R₆, R₇, R₈, R₉, R₁₀, R₁₁ and R₁₂ are each hydrogen, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, R₉, R₁₁ = H, and R₂, R₄, R₆, R₈, R₁₀, R₁₂ = alkyl with C₁-C₂₀, cycloalkyl with Cₗ-C₂₀, alkenyl with C₁-C₂₀, alkynyl with C₁-C₂₀, aryl, heteroaryl, -NR₂ or -OR, excluding the structure 65b' where R₁, R₂, R₃, R₄, R₅, R₆, R₇, R₈, R₉, R₁₀, R₁₁ and R₁₂ = H, excluding the ligand where R₉ , R₁₀, R₁₁ and R₁₂ = phenyl, methyl, allyl, RSCH₂- and ROCH₂-, excluding the ligand where R₉ = phenyl, R₁₀ = H, R₁₁ = phenyl, R₁₂ = H, excluding the ligand where R₁ = phenyl, excluding the ligand where R₅, R₆, R₇, R₈ = phenoxy, or
- in the structural elements c and/or d, C may be replaced by Si, or
- optionally, a or b or e or f may be NR where R = alkyl with C₁-C₂₀, cycloalkyl with C₁-C₂₀, alkenyl with C₁-C₂₀, alkynyl with C₁-C₂₀, aryl, heteroaryl, or
- optionally, a and f or b and e may be NR where R = alkyl with C₁-C₂₀, cycloalkyl with C₁-C₂₀, alkenyl with C₁-C₂₀, alkynyl with C₁-C₂₀, aryl, heteroaryl,
- where the a-c, b-d, c-e and d-f bonds, but not simultaneously a-c and c-e and not simultaneously b-d and d-f, may be unsaturated,
- where the a-c, b-d, c-e and d-f bonds may be part of a saturated or unsaturated ring system which may also contain the heteroelements 0, S, Se, N, P, Si, Ge, Sn, or
- the a-c, b-d, c-e and d-f bonds may be part of an aromatic or fused aromatic ring system which may also contain the heteroelements 0, S, Se, N, excluding the ligand in which a-c, b-d, c-e and d-f are part of benzene,
- where the E atom is a main group element, preferably selected from the group of N, P, As, Sb, without being restricted thereto,
- where the structural element a-E-b may optionally be part of a saturated or unsaturated ring system which may also contain the heteroelements O, S, Se, N, P, Si, Ge, Sn, excluding the ligand where a-E-b = part of cyclopentyl and pyranyl where R₉ to R₁₂ = alkyl, or
- the structural element a-E-b may optionally be part of an aromatic ring system which may also contain the heteroelements O, S, Se, N, 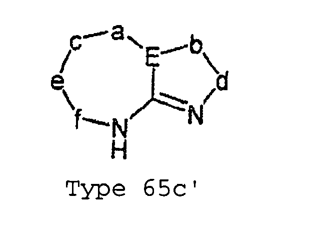 where
- the structural elements a-f may be defined as: a = -CR₁R₂-, b = -CR₃R₄-, c = -CR₅R₆-, d = -CR₇R₈-, e = -CR₉R₁₀- and f = -C₁₁R₁₂-, where R₁, R₂, R₃, R₄, R₅, R₆, R₇, R₈, R₉, R₁₀, R₁₁ and R₁₂ may simultaneously or each independently be H, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, R₉ , R₁₁ = H, and R₂, R₄, R₆, R₈ , R₁₀, R₁₂ = alkyl with C₁-C₂₀, cycloalkyl with C₁-C₂₀, alkenyl with C₁-C₂₀, alkynyl with C₁-C₂₀, aryl, heteroaryl, -NR₂ or -OR, excluding the ligand where R₁ to R₁₂ = H, or
- in c or e, C may be replaced by Si, or
- optionally, a or b or d or f may be NR where R = alkyl with C₁-C₂₀, cycloalkyl with C₁-C₂₀, alkenyl with C₁-C₂₀, alkynyl with C₁-C₂₀, aryl, heteroaryl, or
- optionally, a and d or b and f may be NR where R = alkyl with C₁-C₂₀, cycloalkyl with C₁-C₂₀, alkenyl with C₁-C₂₀, alkynyl with C₁-C₂₀, aryl, heteroaryl,
- where the a-c, c-e, e-f and b-d bonds, but not simultaneously a-c, c-e and e-f and not simultaneously a-c and c-e and not simultaneously c-e and e-f, may be unsaturated,
- where the a-c, c-e, e-f and b-d bonds may be part of a saturated or unsaturated ring system which may also contain the heteroelements O, S, Se, N, P, Si, Ge, Sn, or
- the a-c, c-e, e-f and b-d bonds may be part of an aromatic or fused aromatic ring system which may also contain the heteroelements O, S, Se, N, excluding the ligand where E = N and, simultaneously, e-f and/or b-d is part of benzene or naphthalene, excluding the ligand where E = N and, simultaneously, R₇ = R₈ = phenyl, excluding the ligand where E = N and R₃ = phenyl, benzyl,
- where the E atom is a main group element, preferably selected from the group of N, P, As, Sb, without being restricted thereto, excluding the ligand where E = N and, simultaneously, the seven-membered ring has more than one unsaturated bond,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements O, S, Se, N, 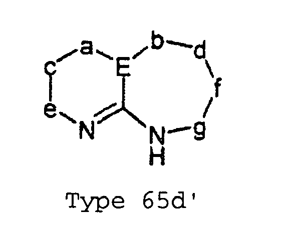 where
- the structural elements a-g may be defined as: a = -CR₁R₂-, b = -CR₃R₄-, c = -CR₅R₆-, d = -CR₇R₈-, e = -CR₉R₁₀-, f = -C₁₁R₁₂- and g = -CR₁₃R₁₄-, where R₁, R₂, R₃, R₄, R₅, R₆, R₇, R₈, R₉ , R₁₀, R₁₁, R₁₂, R₁₃ and R₁₄ may simultaneously or each independently be H, alkyl with C₁-C₂₀, cycloalkyl with C₁-C₂₀, alkenyl with C₁-C₂₀, alkynyl with C₁-C₂₀, aryl, heteroaryl, -NR₂ or -OR; preferably, R₁, R₃, R₅, R₇, R₉, R₁₁, R₁₃ = H, and R₂, R₄, R₆, R₈, R₁₀, R₁₂, R₁₄ = alkyl with C₁-C₂₀, cycloalkyl with C₁-C₂₀, alkenyl with C₁-C₂₀, alkynyl with C₁-C₂₀, aryl, heteroaryl, -NR₂ or -OR, or
- in c, d and f, but not d and f simultaneously, C may be replaced by Si, or
- optionally, a or b or e or g may be NR where R = alkyl with C₁-C₂₀, cycloalkyl with C₁-C₂₀, alkenyl with C₁-C₂₀, alkynyl with C₁-C₂₀, aryl, heteroaryl, or
- optionally, a and g or b and e may be NR where R = alkyl with C₁-C₂₀, cycloalkyl with C₁-C₂₀, alkenyl with C₁-C₂₀, alkynyl with C₁-C₂₀, aryl, heteroaryl,
- where the a-c, c-e, b-d, d-f and f-g bonds, but not simultaneously a-c and c-e, and not simultaneously b-d, d-f and f-g, and not simultaneously b-d and d-f, and not simultaneously d-f and f-g, may be unsaturated, excluding the ligand in which b-d and f-g are simultaneously unsaturated,
- where the a-c, c-e, b-d, d-f and f-g bonds may be part of a saturated or unsaturated ring system which may also contain the heteroelements O, S, Se, N, P, Si, Ge, Sn, or
- the a-c, c-e, b-d, d-f and f-g bonds may be part of an aromatic or fused aromatic ring system which may also contain the heteroelements O, S, Se, N, excluding the ligand in which c-e and f-g are simultaneously part of a benzene ring,
- where the E atom is a main group element, preferably selected from the group of B, C, N, O, Si, P, S, As, Se, Sb, Te, more preferably selected from the group of S, Se, N, P, without being restricted thereto,
- where the structural element a-E-b may optionally be part of a saturated or unsaturated ring system which may also contain the heteroelements O, S, Se, N, P, Si, Ge, Sn, or
- the structural element a-E-b may optionally be part of an aromatic ring system which may also contain the heteroelements O, S, Se, N.

3. Process according to Claim 2, **characterized in that** the solvent is an ether, an aromatic solvent or a mixture thereof.

4. Process according to Claim 3, **characterized in that** the ether is dialkyl ether, cyclic ether, cyclic and/or open-chain polyether.

5. Process according to any one of Claims 2 to 4, **characterized in that** the reducing agent is a base metal.

6. Process according to Claim 5, **characterized in that** the base metal is sodium, potassium and/or caesium.

7. Process according to any one of Claims 2 to 6, **characterized in that** the isolation is effected by crystallization, precipitation and/or sublimation.

8. Semiconductive material comprising a metal complex according to Claim 1 in the form of an electrically contactable layer or of an electrical conduction path arranged on a substrate.

9. Organic semiconductive material comprising at least one organic matrix compound and an n-dopant, **characterized in that** the n-dopant is one or more metal complexes according to Claim 1.

10. Organic semiconductive material according to Claim 9, **characterized in that** the molar doping ratio of dopant to matrix molecule or the doping ratio of dopant to monomeric units of a polymeric matrix molecule is between 1:1 and 1:100 000.

11. Process for preparing an organic semiconductive material comprising an organic matrix molecule and an n-dopant, **characterized in that** the n-dopant(s) used is/are one or more metal complexes according to Claim 1.

12. Electronic component comprising an n-doped organic semiconductor layer, **characterized in that** the n-dopant is at least one or more than one of the metal complexes according to Claim 1.

13. Electronic component according to Claim 12 in the form of an organic light-emitting diode (OLED), of a photovoltaic cell, of an organic solar cell, of an organic diode or of an organic field-effect transistor, in which the semiconductive organic material doped with at least one dopant according to Claim 1 is an electronically functionally active part of the electronic component.

14. Use of a metal complex according to Claim 1 as an injection layer in electronic components.

## Revendications

1. Complexe métallique en vue du dopage d'un matériau de matrice semi-conducteur organique, qui présente une structure qui est sélectionnée parmi le groupe : 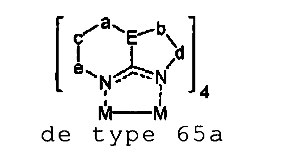 dans lequel
◆ les éléments de structure a-e peuvent avoir la signification a = -CR₁R₂-, b = -CR₃R₄-, c = -CR₅-R₆-, d = -CR₇R₈- et e = -CR₉R₁₀-, R₁, R₂, R₃, R₄, R₅, R₆, R₇, R₈, R₉ et R₁₀ étant, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, NR₂ ou -OR, R₁, R₃, R₅, R₇, R₉, étant, de préférence, H et R₂, R₄, R₆, R₈, R₁₀ étant un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR ou
◆ au choix, a ou b ou e ou d pouvant être NR avec R = un alkyle en C₁-C₂₀, un cycloalkyle en C₁-C₂₀, un alcényle en C₁-C₂₀, un alcynyle en C₁-C₂₀, un aryle, un hétéroaryle ou
◆ pour c C est remplacé par Si,
◆ les liaisons b-d et c-e ou b-d et a-c pouvant être simultanément ou indépendamment les unes des autres insaturées,
◆ les liaisons b-d, a-c et c-e pouvant faire partie, simultanément ou indépendamment les unes des autres, d'un système de cycles saturé ou insaturé, qui peut contenir également les hétéro-éléments O, S, Se, N, P, Si, Ge, Sn ou
◆ les liaisons b-d, a-c et c-e pouvant faire partie, simultanément ou indépendamment les unes des autres, d'un système de cycles aromatique condensé ou aromatique, qui peut contenir également les hétéro-éléments O, S, Se, N ou
◆ l'atome E étant un élément des groupes principaux sélectionné, de préférence, parmi le groupe N, P, As, Sb, sans être limité à celui-ci,
◆ l' élément de structure a-E-b pouvant être au choix un constituant d'un système de cycles saturé ou insaturé, qui peut également contenir les hétéro-éléments O, S, Se, N, P, Si, Ge, Sn ou
◆ l'élément de structure a-E-b pouvant être au choix un constituant d'un système de cycles aromatique, qui peut également contenir les hétéro-éléments O, S, Se, N,
◆ le métal M étant un métal de transition, de préférence, W ou Mo; 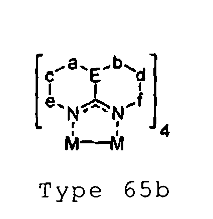 dans lequel
◆ les éléments de structure a-f peuvent avoir la signification a = -CR₁R₂-, b = -CR₃R₄-, c = -CR₅-R₆-, d = -CR₇R₈-, e = -CR₉R₁₀- et f = -CR₁₁R₁₂, R₁, R₂, R₃, R₄, R₅, R₆, R₇, R₈, R₉, R₁₀, R₁₁ et R₁₂ étant l'hydrogène, un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, R₁, R₃, R₅, R₇, R₉, R₁₁ étant, de préférence, H et R₂, R₄, R₆, R₈, R₁₀, R₁₂ étant un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR, la structure 65b avec R₁, R₂, R₃, R₄, R₅, R₆, R₇, R₈, R₉, R₁₀, R₁₁ et R₁₂ = H en étant exclue ou
◆ dans le cas des éléments de structure c et/ou d, C pouvant être remplacé par Si ou
◆ au choix a ou b ou e ou f pouvant être NR avec R = alkyle en C₁-C₂₀, cycloalkyle en C₁-C₂₀, un alcényle en C₁-C₂₀, un alcynyle en C₁-C₂₀, un aryle, un hétéroaryle ou
◆ au choix, a ou f ou b et e pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ les liaisons a-c, b-d, c-e et d-f, mais non simultanément a-c et c-e et non simultanément bd et d-f, pouvant être insaturés,
◆ les liaisons a-c, b-d, c-e et d-f pouvant faire partie d'un système de cycles saturé ou insaturé, qui peut contenir également les hétéro éléments O, S, Se, N, P, Si, Ge, Sn ou
◆ les liaisons a-c, b-d, c-e et d-f pouvant faire partie d'un système de cycles aromatique ou condensé aromatique, qui peut contenir également les hétéro éléments O, S, Se, N ou
◆ l'atome E étant un élément des groupes principaux sélectionné, de préférence, parmi le groupe N, P, As, Sb, sans être limité à celui-ci,
◆ l'élément de structure a-E-b pouvant être au choix un constituant d'un système de cycles saturé ou insaturé, qui peut également contenir les hétéro éléments O, S, Se, N, P, Si, Ge, Sn ou
◆ l'élément de structure a-E-b pouvant être au choix un constituant d'un système de cycles aromatique, qui peut également contenir les hétéro-éléments O, S, Se, N,
◆ le métal M étant un métal de transition, de préférence, W ou Mo; 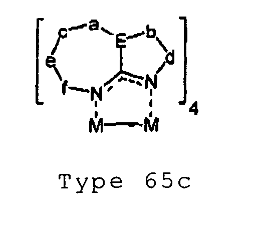 dans lequel
◆ les éléments de structure a-f peuvent avoir la signification a = -CR₁R₂-, b = -CR₃R₄-, c = -CR₅-R₆-, d = -CR₇R₈-, e = -CR₉R₁₀- et f = CR₁₁R₁₂, R₁, R₂, R₃, R₄, R₅, R₆, R₇, R₈, R₉, R₁₀, R₁₁ et R₁₂ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR; R₁, R₃, R₅, R₇, R₉, R₁₁étant, de préférence, H et R₂, R₄, R₆, R₈, R₁₀, R₁₂ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR ou
◆ pour c ou e C pouvant être remplacé par Si ou
◆ au choix a ou b ou d ou f pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ au choix a et d ou b et f pouvant être NR avec R = alkyle en C₁-C₂₀, cycloalkyle en C₁-C₂₀, alcényle en C₁-C₂₀, alcynyle en C₁-C₂₀, aryle, hétéroaryle,
◆ les liaisons a-c, c-e, e-f et b-d, mais cependant non simultanément a-c et c-e et e-f et non simultanément a-c et c-e et non simultanément ce et e-f, pouvant être insaturées,
◆ les liaisons a-c, c-e, e-f et b-d pouvant faire partie d'un système de cycles saturé ou insaturé, qui peut contenir également les hétéro éléments O, S, Se, N, P, Si, Ge, Sn ou
◆ les liaisons a-c, c-e, e-f et b-d pouvant faire partie d'un système de cycles aromatique ou condensé aromatique, qui peut contenir également les hétéro éléments O, S, Se, N ou
◆ l'atome E étant un élément des groupes principaux sélectionné, de préférence, parmi le groupe N, P, As, Sb, sans être limité à celui-ci,
◆ l'élément de structure a-E-b pouvant être au choix un constituant d'un système de cycles saturé ou insaturé, qui peut également contenir les hétéro éléments O, S, Se, N, P, Si, Ge, Sn ou
◆ l'élément de structure a-E-b pouvant être au choix un constituant d'un système de cycles aromatiques, qui peut également contenir les hétéro-éléments O, S, Se, N,
◆ le métal M étant un métal de transition, de préférence, W ou Mo; ou 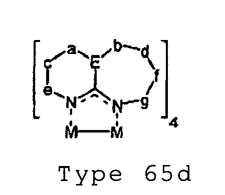
◆ les éléments de structure a-g pouvant avoir la signification a = -CR₁R₂-, b = -CR₃R₄-, c = -CR₅-R₆-, d = -CR₇R₈-, e = -CR₉R₁₀-, f = CR₁₁R₁₂ et g = CR₁₃R₁₄, R₁, R₂, R₃, R₄, R₅, R₆, R₇, R₈, R₉, R₁₀, R₁₁, R₁₂, R₁₃ et R₁₄ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR; R₁, R₃, R₅, R₇, R₉, R₁₁, et R₁₃ étant H et R₂, R₄, R₆, R₈, R₁₀, R₁₂ et R₁₄ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR ou
◆ pour c, d et f, toutefois pas pour d et f simultanément, C pouvant être remplacé par Si ou
◆ au choix, a ou b ou e ou g pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ au choix, a et g ou b et e pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ les liaisons a-c, c-e, b-d, d-f et f-g, mais cependant non simultanément a-c et c-e, et non simultanément b-d, d-f et f-g, et non pas simultanément b-d et d-f, et non pas simultanément d-f et f-g, pouvant être insaturés,
◆ les liaisons a-c, c-e, b-d, d-f et f-g pouvant faire partie, simultanément ou indépendamment les unes des autres, d'un système de cycles saturé ou insaturé, qui peut contenir également les hétéro éléments 0, S, Se, N, P, Si, Ge, Sn ou
◆ les liaisons a-c, c-e, b-d, d-f et f-g pouvant faire partie d'un système de cycles aromatique ou condensé aromatique, qui peut contenir également les hétéro éléments O, S, Se, N ou
◆ l'atome E étant un élément des groupes principaux sélectionné, de préférence, parmi le groupe N, P, As, Sb, sans être limité à celui-ci,
◆ l'élément de structure a-E-b pouvant être au choix un constituant d'un système de cycles saturé ou insaturé, qui peut également contenir les hétéro éléments O, S, Se, N, P, Si, Ge, Sn ou l'élément de structure a-E-b pouvant être au choix un constituant d'un système de cycles aromatique, qui peut également contenir les hétéro-éléments O, S, Se, N,
◆ le métal M étant un métal de transition, de préférence, W ou Mo.

2. Procédé en vue de la fabrication d'un complexe métallique selon la revendication 1, qui comprend les étapes :
(a) de transformation d'un sel métallique inorganique de l'atome central M avec une base libre d'un ligand dans un solvant organique en présence d'un agent de réduction et de chauffage sous reflux,
(b) d'isolement du produit obtenu après la réaction et après le séchage, le ligand étant sélectionné parmi le groupe se composant de 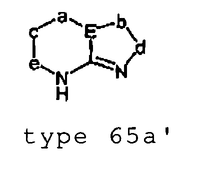 dans lequel
◆ les éléments de structure a-e pouvant avoir la signification a = -CR₁R₂-, b=-CR₃R₄-, c = -CR₅R₆-, d= -CR₇R₈- et e ₌ -CR₉R₁₀-, R₁, R₂, R₃, R₄, R₅, R₆, R₇, R₈, R₉, R₁₀ pouvant être, simultanément ou indépendamment les uns des autres H, un alkyle en Cₗ-C₂₀, un cycloalkyle en C₁-C₂₀, un alcényle en Cₗ-C₂₀, un alcynyle en C₁-C₂₀, un aryle, un hétéroaryle, -NR₂ ou -OR; R₁, R₃, R₅, R₇, R₉ étant, de préférence, H et R₂, R₄, R₆, R₈, R₁₀ étant un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR, la structure 65a avec R₁ à R₁₀ = H en étant exclu, R₁ et R₁₀ dans la structure 65a étant toujours H ou
◆ au choix, a ou b ou e ou d pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ au choix, a et d ou b et e pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ pour c C est remplacé par Si,
◆ les liaisons b-d et c-e ou b-d et a-c pouvant être, simultanément ou indépendamment insaturées les unes des autres, les liaisons b-d, a-c et c-e pouvant faire partie, simultanément ou indépendamment les unes des autres, d'un système de cycles saturé ou insaturé, qui peut aussi contenir les hétéroéléments O, S, Se, N, P, Si, Ge, Sn, le ligand ayant c-e = cyclohexyle et cyclohexényle, en étant exclu ou
◆ les liaisons b-d, a-c et c-e faisant partie, simultanément ou indépendamment les unes des autres, d'un système de cycles aromatique ou condensé aromatique, qui peut aussi contenir les hétéro-éléments O, S, Se, N, le ligand pour lequel b-d, a-c et c-e font partie du benzène, en étant exclu,
◆ l'atome E étant un élément des groupes principaux sélectionné, de préférence, parmi le groupe N, P, As, Sb, sans être limité à celui-ci,
◆ l'élément de structure a-E-b pouvant être au choix un constituant d'un système de cycles saturé ou insaturé, qui peut également contenir les hétéro éléments O, S, Se, N, P, Si, Ge, Sn ou
◆ l'élément de structure a-E-b pouvant être au choix un constituant d'un système de cycles aromatique, qui peut également contenir les hétéro-éléments O, S, Se, N, 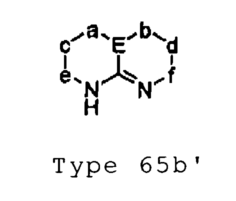 dans lequel
◆ les éléments de structure a-f peuvent avoir la signification a = -CR₁R₂-, b = -CR₃R₄-, c=-CR₅R₆-, d= -CR₇R₈-, e = -CR₉R₁₀- et f = -CR₁₁R₁₂-, R₁, R₂, R₃, R₄, R₅, R₆, R₇,
◆ l'atome E étant un élément des groupes principaux sélectionné, de préférence, parmi le groupe N, P, As, Sb, sans être limité à celui-ci,
◆ l'élément de structure a-E-b pouvant faire partie d'un système de cycles saturé ou insaturé, qui peut aussi contenir les hétéroéléments O, S, Se, N, P, Si, Ge, Sn, le ligand avec a-E-b = constituant du cyclopentyle ainsi que du pyrannyle avec R₉ à R₁₂ = alkyle en étant exclu ou
◆ l'élément de structure a-E-b pouvant être au choix un constituant d'un système de cycles aromatique, qui peut également contenir les hétéroéléments O, S, Se, N, 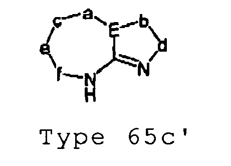 dans lequel
◆ les éléments de structure a-f peuvent avoir la signification a = -CR₁R₂-, b = -CR₃R₄-, c = -CR₅R₆-, d = -CR₇R₈-, e = -CR₉R₁₀- et f = CR₁₁R₁₂-, R₁, R₂, R₃, R₄, R₅, R₆, R₇, R₈, R₉, R₁₀, R₁₁ et R₁₂ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR; R₁, R₃, R₅, R₇, R₉, R₁₁ étant, de préférence, H et R₂, R₄, R₆, R₈, R₁₀, R₁₂ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR, le ligand avec R₁ à R_{12 =} H en étant exclu ou
◆ pour c ou e C pouvant être remplacé par Si ou
◆ au choix, a ou b ou d ou f pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ au choix, a et d ou b et f pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ les liaisons a-c, c-e, e-f et b-d, mais cependant non simultanément a-c, c-e et e-f et non simultanément a-c et c-e et non simultanément ce et e-f, pouvant être insaturées,
◆ les liaisons a-c, c-e, e-f et b-d pouvant faire partie, simultanément ou indépendamment les uns des autres, d'un système de cycles saturés ou insaturés, qui peut contenir également les hétéro éléments O, S, Se, N, P, Si, Ge, Sn ou
◆ les liaisons a-c, c-e, e-f et b-d pouvant faire partie d'un système de cycles aromatique ou condensé aromatique, qui peut aussi contenir les hétéroéléments O, S, Se, N" le ligand avec E=N et simultanément e-f et/ou b-d faisant partie du benzène et du naphtalène en étant exclu, le ligand avec E= N et simultanément R₇ = R₈ = phényle en étant exclu, le ligand avec E=N et R₃ = phényle, benzyle en étant exclu,
◆ l'atome E étant un élément de groupes principaux, sélectionné, de préférence, parmi le groupe N, P, As, Sb, sans y être limité, à l'exception du ligand avec E=N et simultanément le cycle à sept membres ayant plus d'une liaison insaturée,
◆ l'élément de structure a-E-b pouvant être au choix un constituant d'un système de cycles saturé ou insaturé, qui peut également contenir les hétéro éléments O, S, Se, N, P, Si, Ge, Sn ou
◆ l'élément de structure a-E-b pouvant être au choix un constituant d'un système de cycles aromatiques, qui peut également contenir les hétéroéléments O, S, Se, N, 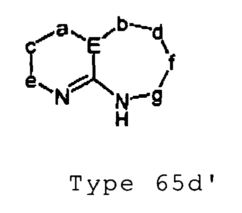 dans lequel
◆ les éléments de structure a-g pouvant avoir la signification a = -CR₁R₂-, b = -CR₃R₄-, c = -CR₅R₆-, d = -CR₇R₈-, e = -CR₉R₁₀-, f = CR₁₁R₁₂, et g = CR₁₃R₁₉, R₁, R₂, R₃, R₄, R₅, R₆, R₇, R₈, R₉, R₁₀, R₁₁, R_{12,} R₁₃ et R₁₄ pouvant être, simultanément ou indépendamment les uns des autres, H, un alkyle en C₁-C₂₀, un cycloalkyle en C₁-C₂₀, un alcényle en C₁-C₂₀, un alcynyle en C₁-C₂₀, un aryle, un hétéroaryle, -NR₂ ou -OR; R₁, R₃ R₅, R₇, R₉, R₁₁, R₁₃ étant, de préférence, H et R₂, R₄, R₆, R₈, R₁₀, R₁₂, R₁₄ étant un alkyle en C₁-C₂₀, un cycloalkyle en C₁-C₂₀, un alcényle en C₁-C₂₀, un alcynyle en C₁-C₂₀, un aryle, un hétéroaryle, - NR₂ ou -OR ou
◆ pour c, d et f, toutefois non pour d et f simultanément, C pouvant être remplacé par Si ou
◆ au choix, a ou b ou e ou g pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ au choix, a et g ou b et e pouvant être NR avec R = alkyle en C₁-C₂₀, cycloalkyle en C₁-C₂₀, alcényle en C₁-C₂₀, alcynyle en C₁-C₂₀, aryle, hétéroaryle ou
◆ les liaisons a-c, c-e, b-d, d-f et f-g, mais cependant non simultanément a-c et c-e, et non simultanément b-d, d-f et f-g, et non simultanément b-d et d-f, et non simultanément d-f et f-g, pouvant être insaturés, le ligand pour lequel b-d et f-g sont simultanément insaturés en étant exclu,
◆ les liaisons a-c, c-e, b-d, d-f et f-g pouvant faire partie d'un système de cycles saturé ou insaturé, qui peut contenir également les hétéro éléments O, S, Se, N, P, Si, Ge, Sn ou
◆ les liaisons a-c, c-e, b-d, d-f et f-g pouvant faire partie d'un système de cycles aromatique ou condensé aromatique, qui peut contenir également les hétéro éléments O, S, Se, N, le ligand pour lequel c-e et f-g font partie simultanément d'un cycle benzène en étant exclu,
◆ l'atome E étant un élément des groupes principaux, sélectionné, de préférence, parmi le groupe B, C, N, O, Si, P, S, As, Se, Sb, Te, sélectionné, en particulier, de préférence, parmi le groupe S, Se, N, P, sans y être limité,
◆ l'élément de structure a-E-b pouvant être au choix un constituant d'un système de cycles saturé ou insaturé, qui peut également contenir les hétéro éléments O, S, Se, N, P, Si, Ge, Sn ou
◆ l'élément de structure a-E-b pouvant être au choix un constituant d'un système de cycles aromatique, qui peut également contenir les hétéro-éléments O, S, Se, N.

3. Procédé selon la revendication 2, **caractérisé en ce que** le solvant est un éther, un solvant aromatique, ou un mélange de ces derniers.

4. Procédé selon la revendication 3, **caractérisé en ce que** l'éther est un éther dialkylique, un éther cyclique, un polyéther cyclique et/ou un polyéther à chaîne ouverte.

5. Procédé selon l'une quelconque des revendications 2 à 4, **caractérisé en ce que** l'agent de réduction est un métal non noble.

6. Procédé selon la revendication 5, **caractérisé en ce que** le métal non noble est le sodium, le potassium et/ou le césium.

7. Procédé selon l'une quelconque des revendications 2 à 6, **caractérisé en ce que** l'isolement se fait par cristallisation, précipitation et/ou par sublimation.

8. Matériau semi-conducteur avec un complexe métallique selon la revendication 1, sous la forme d'une couche capable de mise en contact par voie électrique ou d'un trajet de conduction électrique disposé sur un substrat.

9. Matériau semi-conducteur organique contenant au moins un composé de matrice organique et un dopant n, **caractérisé en ce que** le dopant n est un ou plusieurs complexe(s) métallique(s) selon la revendication 1.

10. Matériau semi-conducteur organique selon la revendication 9, **caractérisé en ce que** le rapport de dopage molaire du dopant à la molécule de matrice ou le rapport de dopage du dopant aux unités monomères d'une molécule de matrice polymère est compris entre 1 :1 et 1 :100000.

11. Procédé en vue de la fabrication d'un matériau semi-conducteur organique contenant une molécule de matrice organique et un dopant n, **caractérisé en ce que** l'on utilise en tant que dopant n, au moins un ou plusieurs complexes métalliques selon la revendication 1.

12. Élément de construction électronique comprenant une couche de semi-conducteur organique n-dopée, **caractérisé en ce que** le dopant n est tout au moins un ou plusieurs complexes métalliques selon la revendication 1.

13. Élément de construction électronique selon la revendication 12, sous la forme d'une diode électroluminescente organique (DELO), d'une cellule photovoltaïque, d'une cellule solaire organique, d'une diode organique ou d'un transistor à effet de champ organique, dans le cas duquel le matériau organique semi-conducteur, dopé à l'aide d'un dopant selon la revendication 1, représente une pièce active fonctionnelle électronique d'un élément de construction électronique.

14. Utilisation d'un complexe métallique selon la revendication 1, en tant que couche d'injection dans des éléments de construction électroniques.
